# EUROPEAN PATENT APPLICATION

(11) **EP 4 669 078 A1**
(43) Date of publication of application: **24.12.2025**
(21) Application number: 25184225.8
(22) Date of filing: 20.06.2025
(51) Int. Cl.: H10K 59/131

(54) **DISPLAY DEVICE AND ELECTRONIC DEVICE INCLUDING THE SAME**

(30) Priority: 21.06.2024 KR 20240081070; 11.09.2024 KR 20240123978
(71) Applicant: Samsung Display Co., Ltd., Yongin-si, Gyeonggi-do 17113 (KR)
(72) Inventor: PARK, Hyun Ae, 17113 Yongin-si (KR); KWON, Tae Hoon, 17113 Yongin-si (KR)
(74) Representative: Taor, Simon Edward William

(57) **Abstract**

A display device is disclosed that includes first and second gate lines extending in a first direction and arranged along a second direction. Data lines extend in the second direction and are arranged along the first direction. First pixels are connected to the first gate line in common and the data lines respectively. Second pixels are connected to the second gate line in common and the data lines respectively. Connection lines are disposed between the first and second gate lines, and at least one of the connection lines is connected to a corresponding data line. Each of the first and second pixels includes a light emitting element and a pixel circuit including transistors. The pixel circuit of a first pixel of the first pixels and the pixel circuit of a second pixel of the seconds pixel are symmetrical with respect to a connection line of the connection lines in a plan view.

## Description

### CROSS-REFERENCE TO RELATED PATENT APPLICATION

The present application claims priority to Korean patent application number 10-2024-0081070 filed on June 21, 2024, and Korean patent application number 10-2024-0123978 filed on September 11, 2024, in the Korean Intellectual Property Office.

### BACKGROUND

### 1. Field

Embodiments of the present disclosure relate to a display device and an electronic device including the same.

### 2. Description of the Related Art

In recent years, as interest in information display has increased, research and development of display devices has been carried out continuously.

### SUMMARY

The present disclosure may provide a display device and an electronic device that reduces a signal delay.

Features of the present disclosure are not limited to the object mentioned feature, and other technical features may be understood by a person skilled in the art from the following description.

A display device according to embodiments of the present disclosure includes a first gate line and a second gate line extending in a first direction and arranged along a second direction that intersects the first direction, data lines extending in the second direction and arranged along the first direction, first pixels connected to the first gate line, and connected to the data lines respectively, second pixels connected to the second gate line in common, and connected to the data lines respectively, and connection lines disposed between the first gate line and the second gate line, at least one of the connection lines being connected to a corresponding data line among the data lines. Each of the first and second pixels includes a light emitting element and a pixel circuit, and the pixel circuit includes transistors. The pixel circuit of a first pixel of the first pixels and the pixel circuit of a second pixel of the second pixels are mutually symmetrical with respect to a connection line of the connection lines in a plan view.

The first pixels may be disposed in a first row, and the second pixels may be disposed in a second row adjacent to the first row.

The transistors of the second pixels may be disposed to be symmetrical to the transistors of the first pixels with respect to one of the connection lines in a plane view.

The first gate line and the second gate line may have shapes symmetrical with respect to one of the connection lines in a plan view.

The connection lines may extend in the first direction, may be arranged along the second direction between the first gate line and the second gate line, and may be connected to different data lines from each other among the data lines.

Each of the first pixels and the second pixels may include a first switching transistor which is connected to a corresponding data line among the data lines and of which a gate electrode is electrically connected to one of the first and second gate lines.

The display device may further include a power line that extends in the first direction between the first gate line and the second gate line, the first pixels and the second pixels may be connected to the power line in common, and each of the first pixels and the second pixels may include a second switching transistor which is connected to the power line and of which a gate electrode is electrically connected to one of the first and second gate lines.

At least two connection lines may be disposed between the first gate line and the second gate line.

Four connection lines may be disposed between the first gate line and the second gate line.

Three connection lines may be disposed between the first gate line and the second gate line.

Two pixels adjacent to each other among the first pixels may be symmetrical with respect to one of the data lines.

The display device may further include bridge lines disposed between two data lines adjacent to each other among the data lines, extending in the second direction, and connected to a corresponding connection line among the connection lines, and the first pixel may receive a data signal sequentially passing through a bridge line of the bridge lines, a connection line of the connection lines, and a data line of the data lines.

An insulating layer may be disposed between the bridge lines and the connection lines in a cross-sectional view, contact holes that penetrate the insulating layer may be formed between two connection lines adjacent to each other among the connection lines in a plan view, and the bridge line may be connected to the connection line via a first contact hole.

The data line may be connected to the connection line via a second contact hole.

In a plan view, one of the connection lines may have a curved part that extends by bypassing the contact holes.

The pixel circuit may include a first transistor configured to control a current flowing through the light emitting element, a fifth transistor connected between a first power line and the first transistor, a sixth transistor connected between the first transistor and an anode electrode of the light emitting element, and a seventh transistor connected between the anode electrode of the light emitting element and a fourth power line, a first pixel row may include the first pixels and a second pixel row may include the second pixels, the first pixel row may be adjacent to the second pixel row, and the first pixel row and the second pixel row may share the fourth power line.

The pixel circuit may further include an eighth transistor connected between a fifth power line and the first transistor and including a gate electrode connected to a gate electrode of the seventh transistor, the first pixel row and the second pixel row may share the fifth power line.

A display device according to embodiments of the disclosure includes gate lines extending in a first direction and arranged along a second direction that intersects the first direction, data lines extending in the second direction and arranged along the first direction; pixels connected to the gate lines and the data lines in which the pixels are arranged in pixel rows and pixel rows, and connection lines extending in the first direction and disposed between the gate lines, at least one of the connection lines being connected to a corresponding data line among the data lines. At least two connection lines may be disposed for each pixel row, and the pixel row may correspond to each of the gate lines.

The display device may further include bridge lines extending in the second direction and disposed between the data lines, at least one of the bridge lines being connected to a corresponding connection line among the connection lines, the bridge lines may be disposed, one for each of the pixel columns, and the pixel columns may correspond to the data lines.

The display device may further include power lines extending in the first direction and arranged along the second direction at intervals of pairs of adjacent pixel rows of the pixel rows, and the pixels included in each pair of the the pairs of adjacent pixel rows may share a power line of the power lines.

An electronic device according to embodiments of the disclosure includes a processor to provide input image data, and a display device to display an image based on the input image data. The display device includes a first gate line and a second gate line extending in a first direction and arranged along a second direction that intersects the first direction, data lines extending in the second direction and arranged along the first direction, first pixels connected to the first gate line, and connected to the data lines respectively, second pixels connected to the second gate line in common, and connected to the data lines respectively, and connection lines disposed between the first gate line and the second gate line, at least one of the connection lines being connected to a corresponding data line among the data lines. Each of the first and second pixels includes a light emitting element and a pixel circuit, and the pixel circuit includes transistors. Pixel circuits of the first pixels and pixel circuits of the second pixels are mutually symmetrical with respect to a connection line of the connection lines in a plan view.

Other embodiments are included in the detailed descriptions and drawings.

In a display device and an electronic device according to embodiments of the present disclosure, at least two connection lines are arranged between adjacent pixel rows, and a transmission path of a data signal may be shortened by using the connection lines (or an optimal connection line selected from them). Therefore, a signal delay may be reduced and a display quality of the display device may be improved.

In addition, in the display device and the electronic device, pixel circuits (or pixels) of two adjacent pixel rows may have an up-and-down symmetrical structure. In this case, the pixel circuits of two adjacent pixel rows share at least one horizontal power line, and a connection line may be additionally disposed without increasing the area of the pixel circuit.

According to an aspect, there is provided a display device as set out in claim 1. Additional features are set out in claims 2 to 12. According to an aspect, there is provided a display device as set out in claim 13. Additional features are set out in claim 14. According to an aspect, there is provided an electronic device as set out in claim 15.

Effects according to embodiments are not limited to the exemplified ones above, and more diverse effects are included in the present specification.

### BRIEF DESCRIPTION OF THE DRAWINGS

FIGS. 1 and 2 are plan views schematically illustrating a display device according to embodiments.
FIG. 3 is a circuit diagram illustrating an embodiment of a pixel included in the display device of FIG. 1.
FIG. 4 is a plan view schematically illustrating an area of the display device in FIG. 1.
FIGS. 5A, 5B, and 5C are plan views illustrating an embodiment of the display device of FIG. 4.
FIG. 6 is a plan view illustrating a comparative example of the display device of FIG. 4.
FIGS. 7, 8, 9, and 10 are plan views illustrating an embodiment of the display device of FIG. 5B.
FIGS. 11A, 11B, and 11C are plan views illustrating an embodiment of the display device of FIG. 5B.
FIG. 12 is a cross-sectional view illustrating an embodiment of the display device of FIG. 5B.
FIG. 13 is a block diagram schematically illustrating an electronic device according to embodiments.

### DETAILED DESCRIPTION

The advantages and features of the present disclosure, and methods of achieving them will be clarified by making reference to the embodiments described in detail below with the accompanying drawings. However, the present disclosure is not limited to the embodiments disclosed below, but may be embodied in a variety of different forms. These embodiments are provided to ensure that the disclosure of the present disclosure is complete, and to fully show the scope of the disclosure to those skilled in the field of technology to which the disclosure belongs, and the disclosure is defined only by the scope of the claims.

The terminology used in this specification is intended to describe embodiments and is not intended to limit the disclosure. In this specification, a singular form also includes a plural form unless specifically stated otherwise. In the specification, terms such as "comprises" and "includes" (as well as their variations such as "comprising") do not preclude the presence or addition of one or more other components, steps, operations or elements to components, steps, operations or elements mentioned in advance.

As used herein, the word "or" means logical "or" so that, unless the context indicates otherwise, the expression "A, B, or C" means "A and B and C," "A and B but not C," "A and C but not B," "B and C but not A," "A but not B and not C," "B but not A and not C," and "C but not A and not B."

Terms such as "connection" or "link" may refer to any physical or electrical connection or access. This may comprehensively refer to direct or indirect connections or links, as well as integral or non-integral connections or links.

An element or layer being "on" another element or layer includes both the case where the element or layer is directly on the other element or the case where there is another element or layer interposed between them. Throughout the specification, the same reference numerals refer to the same components.

Although the terms "first" and "second" are used to describe various components, these components are not limited by the terms. These terms are merely used to distinguish one component from another component. Accordingly, it should be noted that a first component mentioned below may also be a second component within the technical idea of the present disclosure.

Hereinafter, with reference to the accompanying drawings, embodiments of the present disclosure are described in detail.

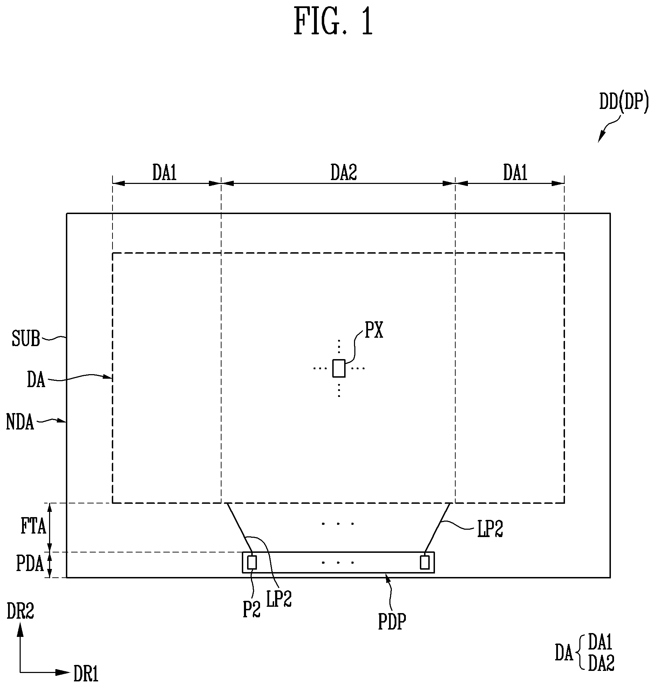

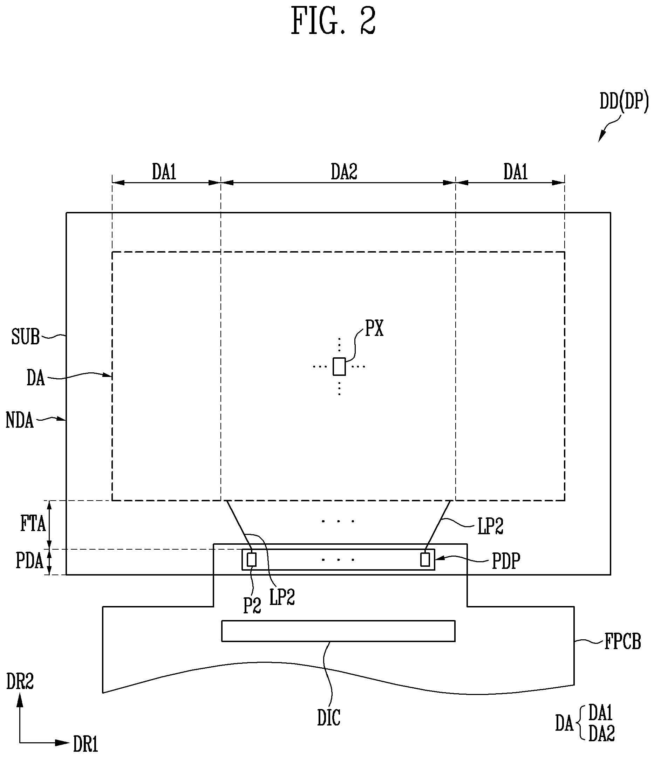

FIGS. 1 and 2 are plan views schematically illustrating a display device according to embodiments.

In FIGS. 1 and 2, for ease of description, a structure of a display device DD, for example, a display panel DP included in the display device DD, is briefly illustrated with a focus on a display area DA in which an image is displayed.

Referring to FIGS. 1 and 2, the display device DD (or display panel DP) may include a substrate SUB and pixels PX (or, subpixels).

The display device DD may be provided in various forms. For example, the display device DD may be provided in the form of a rectangular plate with two pairs of parallel sides, but is not limited thereto. The display device DD to which the present embodiment is applicable may include any electronic device having at least one display side, such as a smartphone, a television, a tablet PC, a mobile phone, a video phone, an e-reader, a desktop PC, a laptop PC, a netbook computers, a workstation, a server, a PDA, a portable multimedia player (PMP), an MP3 player, a medical device, a camera, or a wearable device.

The substrate SUB includes a transparent insulating material, and allows light to transmit. The substrate SUB may be a rigid or flexible substrate.

The rigid substrate may be one of a glass substrate, a quartz substrate, a glass-ceramic substrate, and a crystalline glass substrate.

The flexible substrate may be either a film substrate including a polymeric organic matter, or a plastic substrate. For example, the flexible substrate may include at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate, but is not necessarily limited thereto.

One area of the substrate SUB may be provided as a display area DA in which pixels PX are disposed, and the remaining area of the substrate SUB may be provided as a non-display area NDA.

In embodiments, the display area DA may include a first area DA1 and a second area DA2. The first area DA1 and the second area DA2 may be distinguished based on a first direction DR1. The first area DA1 may be located in both sides of the second area DA2. For example, the second area DA2 may be located in the center of the substrate SUB (or display device DD), and the first area DA1 may be located at an edge of the substrate SUB. The second area DA2 may be located in an inner side, and the first area DA1 may be located in an outer side, but are not necessarily limited thereto. For example, the first area DA1 may be located in one side of the display area DA (e.g., in the right side) and in the other side of the display area DA (e.g., in the left side).

The second area DA2 may be an area of the display area DA that corresponds to a second wiring LP2, and the first area DA1 may be the remaining area of the display area DA excluding the second area DA2.

The second area DA2 may be adjacent to an area of the non-display area NDA where the second wiring LP2 is located, and the first area DA1 may be adjacent to another area of the non-display area NDA.

The pixels PX may be located in the first area DA1 and the second area DA2. Each pixel PX may include a light-emitting element. Depending on embodiments, the light-emitting element may include, but is not limited to, an organic light-emitting diode or an inorganic light-emitting diode having a size in a range of micrometer to nanometer. The display device DD may display an image in the first area DA1 and the second area DA2 by driving the pixels PX in response to input image data.

In addition, in the first area DA1 and the second area DA2, first signal lines connected to the pixels PX may be disposed. For example, in the first area DA1 and the second area DA2, data lines that are connected to the pixels PX may be disposed.

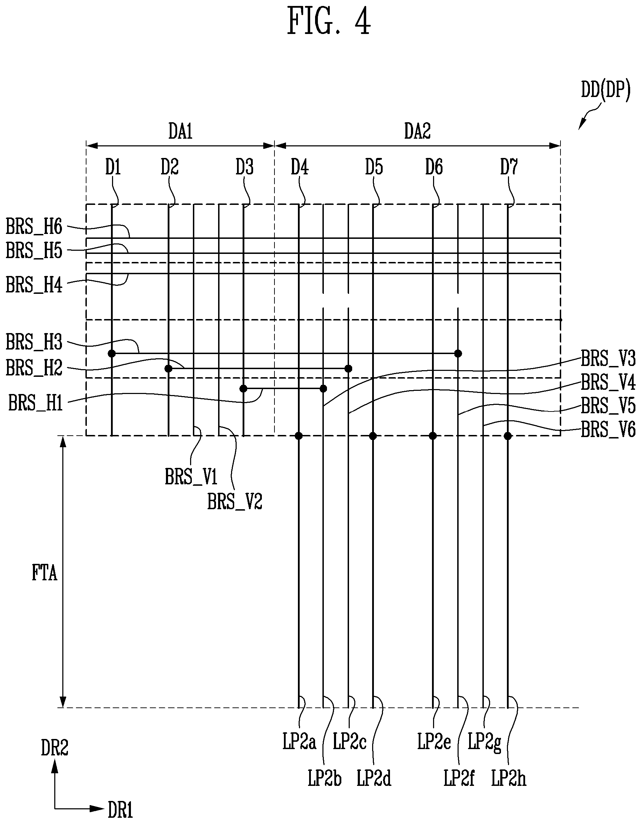

In an embodiment, in the first area DA1 and the second area DA2, second signal lines (or bridge lines) are disposed between the first signal lines, and a connection line, extending from the first area DA1 to the second area DA2 and connecting at least some of the first signal lines of the first area DA1 to the second signal lines of the second area DA2, may be disposed. The second signal lines and the connection line will be described later with reference to FIG. 4.

In the non-display area NDA, a wiring part for driving the pixels PX, a pad part PDP, or an embedded circuit part may be disposed. The non-display area NDA may include a fan-out area FTA and a pad area PDA.

The pad area PDA is an area of the non-display area NDA where the pad part PDP is located, and may be located at an edge of the non-display area NDA.

The fan-out area FTA is an area of the non-display area NDA where the wiring part is located, which may be located between the display area DA and the pad area PDA in the non-display area NDA.

The wiring part may be located in the fan-out area FTA, and the pad part PDP may be located in the pad area PDA.

The wiring part may be electrically connected to signal lines (e.g., data lines connected to the pixels PX) of the display area DA. The wiring part may transmit a predetermined signal applied from a driver DIC to the signal lines in the display area DA. The wiring part may include fan-out lines that electrically connect the driver DIC to the pixels PX.

The wiring part may include a second wiring LP2 (or third signal lines). For example, the second wiring LP2 may be located in the center of the fan-out area FTA to correspond to the second area DA2.

The second wiring LP2 may be disposed in one area of the fan-out area FTA located between the second area DA2 and the pad part PDP. A plurality of the second wirings LP2 may be provided and may include fan-out lines that are electrically connected to the signal lines located in the second area DA2. For example, the second wiring LP2 may include fan-out lines electrically connected to a data line that is connected to the pixels PX and transfer an electrical signal (e.g., a data signal) to the pixels PX from the driver DIC.

In the embodiment, the second wiring LP2 may include fan-out lines that are electrically connected to signal lines (e.g., data lines connected to the pixels PX) located in the first area DA1 via a connection line extending from the first area DA1 to the second area DA2.

Since the signal lines located in the first area DA1 are connected to the second wiring LP2 via a connection line, wiring (or a first wiring) may not be disposed in one area of the fan-out area FTA located between the first area DA1 and the pad part PDP. Thus, the area (e.g., the width in a second direction DR2) of the fan-out area FTA may be reduced, when compared to the case where the first wiring is disposed in one area of the fan-out area FTA located between the first area DA1 and the pad part PDP.

The pad part PDP is disposed in the pad area PDA and may supply driving power sources and signals to drive the pixels PX placed in the display area DA. The pad part PDP may be electrically connected to the wiring part. In the embodiment, the pad part PDP may include a second pad P2 electrically connected to the second wiring LP2.

A plurality of the second pads P2 may be provided. The second pad P2 may be electrically connected to the signal lines (e.g., data lines) located in the second area DA2 via a corresponding second wiring LP2. In addition, the second pad P2 may be electrically connected to a connection line via the corresponding second wiring LP2.

The display device DD may include a circuit board FPCB that is connected to the display panel DP via the pad part PDP. The circuit board FPCB may be, but is not limited to, a flexible circuit board.

The circuit board FPCB may process various signals input from a printed circuit board and output them to the display panel DP. One end of the circuit board FPCB may be attached to the display panel DP, and the other end of the circuit board FPCB may be attached to the printed circuit board. The circuit board FPCB may be connected to the display panel DP and the printed circuit board, respectively, by a conductive adhesive member (e.g., an anisotropic conductive film).

The driver DIC may be mounted on the circuit board FPCB. The driver DIC may be, for example, an integrated circuit (IC). The driver DIC may include a panel driver.

The panel driver may scan the pixels PX sequentially and supply a data signal corresponding to an image data signal to the pixels PX. The display panel DP may display an image corresponding to image data signals.

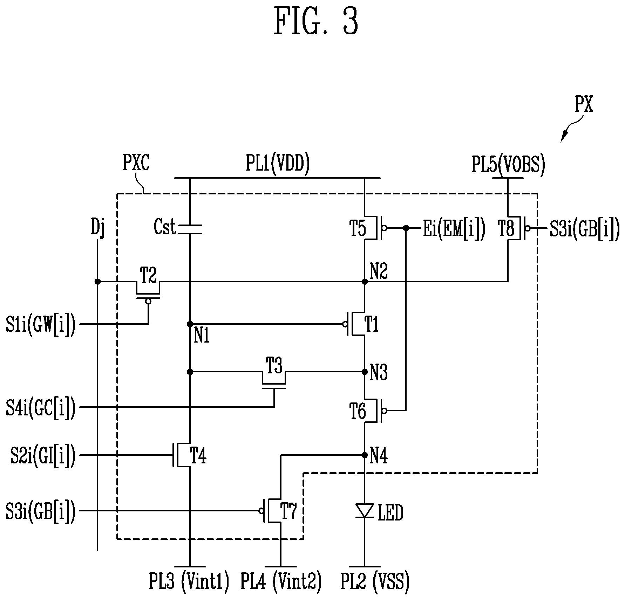

FIG. 3 is a circuit diagram illustrating an embodiment of a pixel included in the display device of FIG. 1. For ease of description, FIG. 3 illustrates a pixel PX located at an i^{th} horizontal line (or i^{th} pixel row) and a j^{th} vertical line (or j^{th} pixel column).

Referring to FIG. 3, the pixel PX may include a light-emitting element LED and a pixel circuit PXC. In an embodiment, the pixel circuit PXC may include first, second, third, fourth, fifth, sixth, seventh, and eighth transistors T1, T2, T3, T4, T5, T6, T7, T8, and a storage capacitor Cst.

The first transistor T1 (or driving transistor) may be connected between a first power line PL1 and a first electrode of the light-emitting element LED. The first transistor T1 may include a gate electrode connected to a first node N1. The first transistor T1 may control the amount of current (or driving current) flowing from the first power line PL1 to a second power line PL2 via a light-emitting element LED based on a voltage of the first node N1. A first power voltage VDD may be provided in the first power line PL1 and a second power voltage VSS may be provided in the second power line PL2. The first power voltage VDD may be set to a higher voltage than the second power voltage VSS.

The second transistor T2 (or a first switching transistor) may be connected between a j^{th} data line Dj and a second node N2. A gate electrode of the second transistor T2 may be connected to a 1i^{th} scan line S11 (or first scan line, first gate line). The second transistor T2 may be turned on when a first scanning signal GW[i] (e.g., a low-level first scanning signal) is supplied to the 1i^{th} scan line S11, and may electrically connect the second node N2 to the j^{th} data line Dj. If the first transistor T1 and the third transistor T3 are each in a turned-on state, the second transistor T2 may transfer a data signal of the j^{th} data line Dj to the first node N1 in respond to the first scanning signal GW[i].

The third transistor T3 may be connected between the first node N1 and a third node N3. A gate electrode of the third transistor T3 may be connected to a 4i^{th} scan line S4i (or fourth scan line, fourth gate line). The third transistor T3 may be turned on when a 4i^{th} scanning signal GC[i] is supplied to the 4i^{th} scan line S4i. When the third transistor T3 is turned on, the first transistor T1 may have a diode-connected form.

The fourth transistor T4 (or a second switching transistor) may be connected between the first node N1 and a third power line PL3. A gate electrode of the fourth transistor T4 may be connected to a 2i^{th} scan line S2i (or second scan line, second gate line). To the third power line PL3, a first initialization power voltage Vint1 may be provided. The fourth transistor T4 may be turned on by a second scanning signal GI[i] fed to the 2i^{th} scan line S2i. When the fourth transistor T4 is turned on, the first initialization power voltage Vint1 may be supplied to the first node N1 (i.e., the gate electrode of the first transistor T1).

The fifth transistor T5 may be connected between the first power line PL1 and the second node N2. A gate electrode of the fifth transistor T5 may be connected to an i^{th} light emission control line Ei. The sixth transistor T6 may be connected between the third node N3 and the light-emitting element LED (or a fourth node N4). A gate electrode of the sixth transistor T6 may be connected to an i^{th} light emission control line Ei. The fifth transistor T5 and the sixth transistor T6 may be turned off when a light emission control signal EM[i] (e.g., a high-level light emission control signal EM[i]) is supplied to the i^{th} light emission control line Ei, and may be turned on otherwise.

The seventh transistor T7 (or a third switching transistor) may be connected between the first electrode of the light-emitting element LED (i.e., the fourth node N4) and a fourth power line PL4. A gate electrode of the seventh transistor T7 may be connected to a 3i^{th} scan line S3i (or, a third scan line, a third gate line). To the fourth power line PL4, a second initialization power voltage Vint2 may be provided. The second initialization power voltage Vint2 may be the same as or different from the first initialization power voltage Vint1. The seventh transistor T7 may be turned on by a third scanning signal GB[i] provided to the 3i^{th} scan line S3i, and may supply the second initialization power voltage Vint2 to the first electrode of the light-emitting element LED.

The eighth transistor T8 (or third switching transistor) may be connected between a fifth power line PL5 and the second node N2. A gate electrode of the eighth transistor T8 may be connected to the 3i^{th} scan line S3i. In the fifth power line PL5, a bias voltage VOBS may be provided. The eighth transistor T8 may be turned on by a third scanning signal GB[i] fed to the 3i^{th} scan line S3i, and may supply a bias voltage VOBS to the second node N2.

The storage capacitor Cst (or capacitor) may be connected or formed between the first power line PL1 and the first node N1.

In an embodiment, the pixel circuit PXC may include a p-type transistor and an n-type transistor. In an embodiment, the third transistor T3 and the fourth transistor T4 may each be formed as an oxide semiconductor transistor including an oxide semiconductor (or second-type semiconductor). For example, the third transistor T3 and fourth transistor T4 may be n-type oxide semiconductor transistors, and each may include an oxide semiconductor layer as an active layer (or semiconductor pattern). Oxide semiconductor transistors may allow a low temperature process and have lower charge mobility than polysilicon semiconductor transistors. In other words, oxide semiconductor transistors have excellent off-current characteristics. Thus, a current leakage in the third transistor T3 and fourth transistor T4 may be minimized.

The remaining transistors (e.g., first, second, fifth, sixth, seventh, and eighth transistors T1, T2, T5, T6, T7, T8) are formed as polysilicon transistors including silicon semiconductors (or firsttype semiconductors) and each may include a polysilicon semiconductor layer as an active layer. For example, the active layer may be formed through a low-temperature polysilicon process (e.g., a low-temperature poly-silicon (LTPS) process). For example, a polysilicon transistor may be a p-type polysilicon transistor. A polysilicon semiconductor transistor may have a fast response speed which is advantageous, so they may be applied to a switching device that requires fast switching.

FIG. 4 is a plan view schematically illustrating one area of the display device in FIG. 1. FIG. 4 schematically illustrates a data line, a bridge line, a connection line, and a second wiring.

Referring to FIGS. 1 and 4, the second wiring LP2 (see FIG. 1) located in the fan-out area FTA may include a 2a^{th} wiring LP2a, a 2b^{th} wiring LP2b, a 2c^{th} wiring LP2c, a 2d^{th} wiring LP2d, a 2e^{th} wiring LP2e, a 2f^{th} wiring LP2f, a 2g^{th} wiring LP2g, and a 2h^{th} wiring LP2h.

Hereinafter, to refer to at least one of the 2a^{th} to 2h^{th} wiring LP2a to LP2h or the 2a^{th} to 2h^{th} wirings LP2a to LP2h collectively, "second wiring LP2" or "second wirings LP2" is used.

In a first area DA1 and a second area DA2, signal lines in which various signals are applied may be disposed.

In the first area DA1 and the second area DA2, data lines D1 to D7 to which data signals are applied may be disposed. The data lines D1 to D7 extend from the first area DA1 and the second area DA2 in a second direction DR2 and may be aligned (or arranged) along a first direction DR1 intersecting the second direction DR2. The number of data lines D1 to D7 is not particularly limited.

In addition, bridge lines BRS_V1 to BRS_V6 (or vertical bridge lines) may be disposed in the first area DA1 and second area DA2. The bridge lines BRS_V1 to BRS_V6 extend from the first area DA1 and the second area DA2 in the second direction DR2 and may be aligned along the first direction DR1. The bridge lines BRS_V1 to BRS_V6 may be disposed to correspond to the data lines D1 to D7, respectively. The bridge lines BRS_V1 to BRS_V6 are a configuration for reducing a border (or dead space), also known as a border reduction structure.

For example, the first bridge line BRS_V1 and the second bridge line BRS_V2 may be disposed between the second data line D2 and the third data line D3, the third bridge line BRS_V3 and the fourth bridge line BRS_V4 may be disposed between the fourth data line D4 and the fifth data line D5, and the fifth bridge line BRS_V5 and the sixth bridge line BRS_V6 may be disposed between the sixth data line D6 and the seventh data line D7.

In the first area DA1, the first data line D1, the second data line D2, the first bridge line BRS_V1, the second bridge line BRS_V2, and the third data line D3 may be disposed.

In the second area DA2, the fourth data line D4, the third bridge line BRS_V3, the fourth bridge line BRS_V4, the fifth data line D5, the sixth data line D6, the fifth bridge line BRS_V5, the sixth bridge line BRS_V6, and the seventh data line D7 may be disposed. In FIG. 4, only five signal lines are shown to be disposed in the first area DA1, but this is merely an example, for ease of description. In particular, the first area DA1 is an area where signal lines that are not directly connected to the second wirings LP2 of the fan-out area FTA are disposed, and the number of signal lines disposed in the first area DA1 is not particularly limited. For example, dozens of signal lines may be disposed in the first area DA1.

The signal lines in the second area DA2 may be connected directly to the second wirings LP2 via a contact hole. For example, the fourth data line D4 may be connected to the 2a^{th} wiring LP2a, the third bridge line BRS_V3 may be connected to the 2b^{th} wiring LP2b, the fourth bridge line BRS_V4 may be connected to the 2c^{th} wiring LP2c, the fifth data line D5 may be connected to the 2d^{th} wiring LP2d, the sixth data line D6 may be connected to the 2e^{th} wiring LP2e, the fifth bridge line BRS_V5 may be connected to the 2f^{th} wiring LP2f, and the sixth bridge line BRS_V6 may be connected to the 2g^{th} wiring LP2g, and the seventh data line D7 may be connected to the 2h^{th} wiring LP2h.

In embodiments, connection lines BRS_H1 to BRS_H6 may be disposed in the first area DA1 and the second area DA2. The connection lines BRS_H1 to BRS_H6 extend in the first direction DR1 and may be aligned along the second direction DR2. The connection lines BRS_H1 to BRS_H6 may extend from the first area DA1 to the second area DA2.

The connection lines BRS_H1 to BRS_H6 may connect signal lines (e.g., data lines) located in the first area DA1 to corresponding bridge lines BRS_V1 to BRS_V6 located in the second area DA2. For example, the first connection line BRS_H1 may connect the third data line D3 in the first area DA1 to the third bridge line BRS_V3. The second connection lines BRS_H2 may connect the second data line D2 in the first area DA1 to the fourth bridge line BRS V4. The third connection lines BRS_H3 may connect the first data line D1 in the first area DA1 to the fifth bridge line BRS_V5.

In an embodiment, dummy lines may be additionally disposed in the second area DA2. The dummy lines may extend in the second direction DR2 from the bridge lines BRS_V1 to BRS_V6, to be physically separated. Similarly, dummy lines (or dummy connection lines) that extend from the connection lines BRS_H1 to BRS_H6 in the first direction DR1, and are provided in a form of being physically separated from the connection lines BRS_H1 to BRS_H6 may be additionally disposed.

In an embodiment, the dummy lines may be in a floating state. For example, dummy lines may not be directly connected to the data lines D1 to D7, the bridge lines BRS_V1 to BRS_V6, and other lines. In another embodiment, a power voltage may be applied to dummy lines. For example, a second power voltage VSS (see FIG. 3) may be applied to dummy lines and the dummy lines may be connected to a second power line PL2 (see FIG. 3). In this case, a voltage drop (or IR drop) of the second power voltage VSS may be prevented or mitigated. Depending on the embodiment, the dummy lines may be connected to a first power line PL1, a third power line PL3, a fourth power line PL4, or a fifth power line PL5 shown in FIG. 3.

In embodiments, at least two connection lines of the connection lines BRS_H1 to BRS_H6 may be disposed between two adjacent pixel rows.

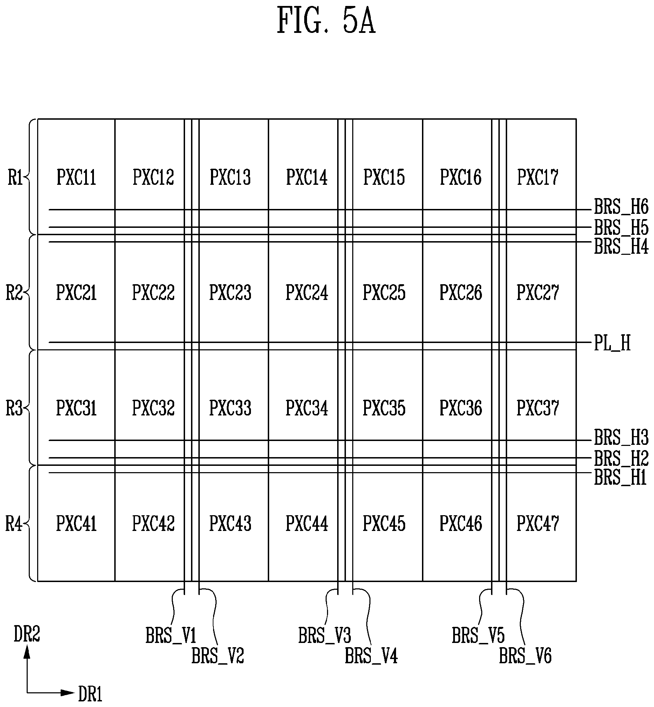

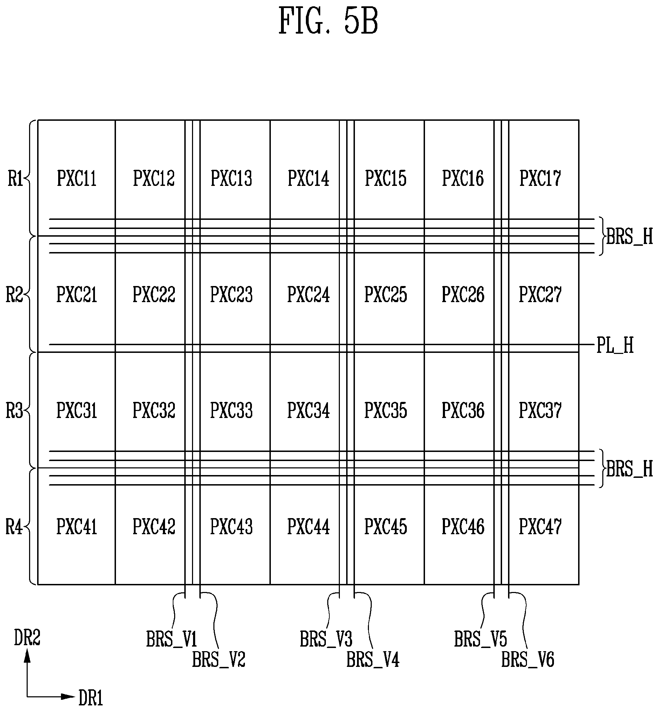

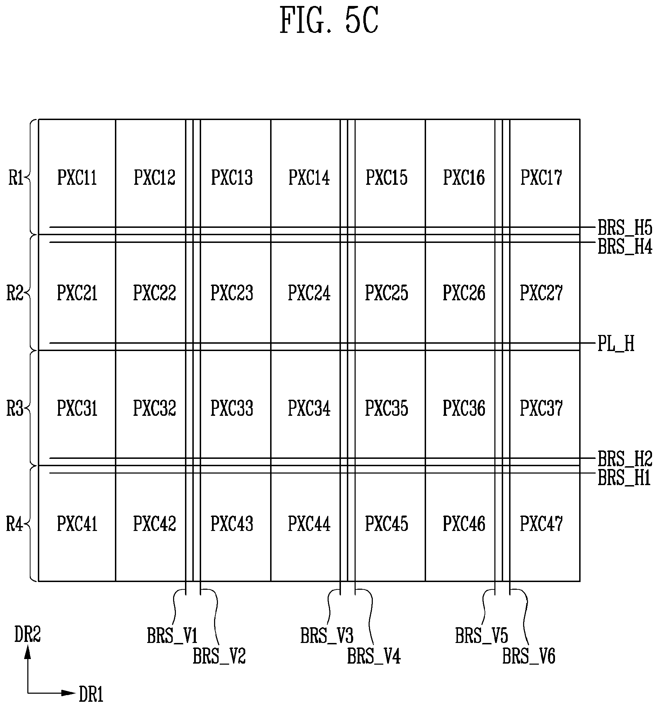

FIG. 5A, 5B, and 5C are plan views illustrating an embodiment of the display device of FIG. 4. FIGS. 5A, 5B, and 5C schematically illustrate examples of a display area with a focus on the connection lines BRS_H1 to BRS_H6 of FIG. 4.

Referring to FIG. 4, and FIGS. 5A to 5C, the display device DD (or display area) may be divided into pixel rows R1 to R4. Each of the pixel rows R1 to R4 extends in a first direction DR1 and may be aligned along a second direction DR2. Pixel circuits PXC11 to PXC47 may be arranged in the pixel rows R1 to R4. Each of the pixel circuits PXC11 to PXC47 may be the pixel circuit PXC of FIG. 3. An "ij^{th} pixel circuit PXCij" is a pixel circuit located in an i^{th} pixel row and a j^{th} pixel column.

**In** an embodiment, the pixel circuits PXC11 to PXC47 included in two adjacent pixel columns may be left-right symmetrical. For example, each of the pixel circuits PXC11 to PXC47 includes transistors T1 to T8 as described by reference to FIG. 3, and the transistors T1 to T8 of a second pixel circuit may be disposed to be respectively symmetrical to the transistors T1 to T8 of a first pixel circuit adjacent to the second pixel circuit in a first direction DR1.

For example, pixel circuits PXC11 to PXC41 in a first pixel column may be symmetrical to pixel circuits PXC12 to PXC42 in a second pixel column, respectively. The pixel circuits PXC12 to PXC42 in the second pixel column may be symmetrical to pixel circuits PXC13 to PXC43 in a third pixel column, respectively, with respect to a first bridge line BRS_V1 or a second bridge line BRS_V2 (or data line). Pixel circuits PXC16 to PXC46 in a sixth pixel column may be symmetrical to pixel circuits PXC17 to PXC47 in a seventh pixel column, respectively, with respect to a fifth bridge line BRS_V5 or a sixth bridge line BRS_V6. In other words, pixel circuits in a k^{th} pixel column may be symmetrical to pixel circuits in a (k+1)^{th} pixel column, respectively. Here, k is a positive integer.

Bridge lines BRS_V1 to BRS_V6 may be disposed, one for each pixel circuit (or each pixel). For example, the first bridge line BRS_V1 may be disposed in the 12^{th} pixel circuit PXC12, and the second bridge line BRS_V2 may be disposed in the 13^{th} pixel circuit PXC13. The disposition of the bridge lines BRS_V1 to BRS_V6 are shown in FIGS. 5A to 5C. A bridge line may also be disposed in the 11^{th} pixel circuit PXC11.

If the pixel circuits PXC11 to PXC47 included in two adjacent pixel columns are left-right symmetrical, the bridge lines BRS_V1 to BRS_V6 may be disposed, two by two between two adjacent pixel columns. For example, the first bridge line BRS_V1 and the second bridge line BRS_V2 may be disposed between the second and third pixel columns, the third bridge line BRS_V3 and the fourth bridge line BRS_V4 may be disposed between fourth and fifth pixel columns, and the fifth bridge line BRS_V5 and sixth bridge line BRS_V6 may be disposed between the sixth and seventh pixel columns. On the other hand, it has been described that two bridge lines are disposed between two adjacent pixel columns, but not limited thereto. For example, three or more bridge lines may be disposed between two adjacent pixel columns.

In an embodiment, the pixel circuits PXC11 to PXC47 included in two adjacent pixel rows R1 to R4 may be vertically symmetrical or flipped. For example, the transistors T1 to T8 (see FIG. 3) of a pixel circuit may be disposed to be respectively symmetrical to the transistors T1 to T8 of a pixel circuit adjacent in the second direction DR2.

For example, the pixel circuits PXC11 to PXC17 in the first pixel row R1 may be symmetrical to the pixel circuits PXC21 to PXC27 in the second pixel row R2, respectively. The pixel circuits PXC21 to PXC27 in the second pixel row R2 may be symmetrical to the pixel circuits PXC31 to PXC37 in the third pixel row R3, respectively. The pixel circuits PXC31 to PXC37 in the third pixel row R3 may be symmetrical to the pixel circuits PXC41 to PXC47 in the fourth pixel row R4, respectively.

In an embodiment, if the pixel circuits PXC11 to PXC47 included in two adjacent pixel rows R1 to R4 are vertically symmetrical, a horizontal power line PL_H may be disposed, one for each pixel row or every two pixel rows, and the pixel circuits PXC11 to PXC47 included in two adjacent pixel rows R1 to R4 may share a single horizontal power line PL_H. Here, the horizontal power line PL_H may be at least one of the third power line PL3, the fourth power line PL4, and the fifth power line PL5 of FIG. 3. For example, a horizontal power line PL_H may disposed between the second pixel row R2 and the third pixel row R3, and the pixel circuits PXC21 to PXC27 of the second pixel row R2 and the pixel circuits PXC31 to PXC37 of the third pixel row R3 may share the horizontal power line PL_H.

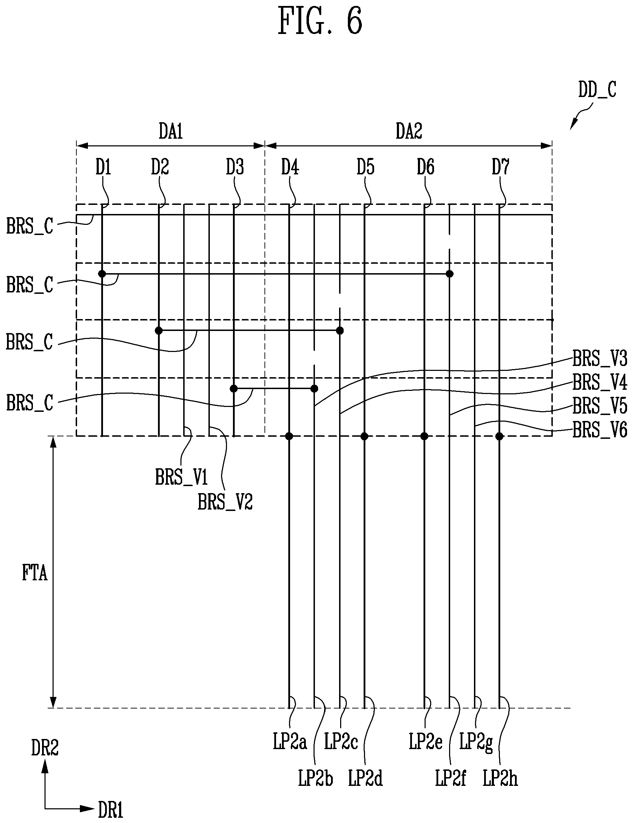

In an embodiment, at least two connection lines of the connection lines BRS_H1 to BRS_H6 may be disposed between two adjacent pixel rows R1 to R4. Referring to FIG. 5A, for example, the fourth connection line BRS_H4, the fifth connection line BRS_H5, and the sixth connection line BRS_H6 may be disposed between the first pixel row R1 and second pixel row R2. For example, the first connection line BRS_H1, the second connection line BRS_H2, and the third connection line BRS_H3 may be disposed between the third pixel row R3 and the fourth pixel row R4. If the pixel circuits PXC11 to PXC47 included in two adjacent pixel rows R1 to R4 are vertically symmetrical, a horizontal power line PL_H may be disposed, one for every two pixel rows (i.e., the number of horizontal power lines PL_H may be reduced compared to the case where a horizontal power line PL_H is disposed for each pixel row), and the number of connection lines may be increased compared to the case where a connection line is disposed for each pixel row. In this case, as will be described later in reference to FIG. 6, a transmission path (or length of a signal line) of a data signal may be shortened by using a larger number of connection lines (or an optimal connection line selected from them), and the resistance and capacitance of the transmission path and a signal delay caused therefrom may be reduced. When a signal delay is reduced, enough time is available to record the data signal to the pixels (e.g., scan on time), the display quality of the display device is improved, the display device may operate at higher speed, or an image may be displayed with a higher refresh rate.

In FIG. 5A depicts three connection lines disposed between two adjacent pixel rows, but embodiments of the disclosure are not limited thereto. For example, as illustrated in FIG. 5B, four connection lines BRS_H may be disposed between two adjacent pixel rows, or two connection lines may be disposed for each pixel row. As another example, as illustrated in FIG. 5C, two connection lines may be disposed between two adjacent pixel rows.

FIG. 6 is a plan view illustrating a comparative example of the display device of FIG. 4.

Referring to FIG. 4 to 6, except for a connection line BRS_C, a display device DD_C of FIG. 6 may be similar to the display device DD of FIG. 4. Therefore, redundant descriptions are omitted.

A connection line BRS_C may be disposed for each pixel row. The connecting line BRS_C may connect a data line located in a first area DA1 to a corresponding bridge line located in a second area DA2. For example, a connection line BRS_C located in a fourth pixel row may connect a third data line D3 and a third bridge line BRS_V3, a connection line BRS_C located in a third pixel row may connect a second data line D2 and a fourth bridge line BRS _V4, and a connection line BRS_Clocated in a second pixel row may connect a first data line D1 and a fifth bridge line BRS_V5.

If three data lines D1 to D3 are disposed in the first area DA1, a data signal may be provided to the first data line D1 (or pixels connected to the first data line D1) by sequentially passing through a 2f^{th} wiring LP2f, the fifth bridge line BRS_V5, and a third connection line BRS_H3 with respect to the first data line D1 which has the longest transmission path of the data signal. Based on a second direction DR2, the data signal is provided from a fan-out area FTA to the first area DA1 through three pixel rows. In other words, the transmission path of the data signal becomes longer in the second direction DR2 as the number of the data lines that receives the data signal through the connection line BRS_Cincreases. As the transmission path becomes longer, the data signal may be delayed, and the data signal may not be properly recorded in a pixel within a predetermined time (e.g., scan on time), or it may be difficult for the display device DD_C to operate at high speed while setting the time longer.

On the other hand, as shown in FIG. 4, in the display device DD according to embodiments, a data signal may be provided to the first area DA1 from the fan-out area FTA through substantially only one pixel row, with respect to the first data line D1 which has the longest transmission path of the data signal. Compared to the display device DD_C of FIG. 6, the transmission path of a data signal may be shortened in the second direction DR2. Referring to FIGS. 4 and 5A, for example, if three connection lines are disposed in two adjacent pixel rows, the transmission path may be shortened to 2/3 or less in the second direction DR2 compared to the display device DD_C in FIG. 6. Referring to FIGS. 4 and 5B, for example, if four connection lines are disposed in two adjacent pixel rows, the transmission path may be shortened to 1/2 or less in the second direction DR2 compared to the display device DD_C in FIG. 6.

As described above, in the display device DD according to embodiments, the wirings (or second wirings) connecting the signal lines in the display area DA (see FIG. 1) and a pad part PDP may be concentrated in a specific area of the fan-out area FTA. Thus, compared to the case where the wirings are disposed generally in the fan-out area FTA, the area of the fan-out area (or dead space) for disposing the wirings may be reduced.

In addition, in the display device DD according to embodiments, at least two connection lines may be disposed between adjacent pixel rows, and the transmission path of a data signal that passes through connection lines may be shortened, so that a signal delay may be reduced. Therefore, the display quality of the display device DD may be improved.

Further, in the display device DD according to embodiments, the pixel circuits (or pixels) of two pixel rows adjacent to each other have a top-bottom symmetrical structure, and thus the pixel circuits may share at least one horizontal power line PL_H (thereby reducing the number of horizontal power lines PL_H), and a connection line may be additionally disposed between two pixel rows adjacent to each other. In other words, the number of connection lines may be increased without increasing the area of a pixel circuit.

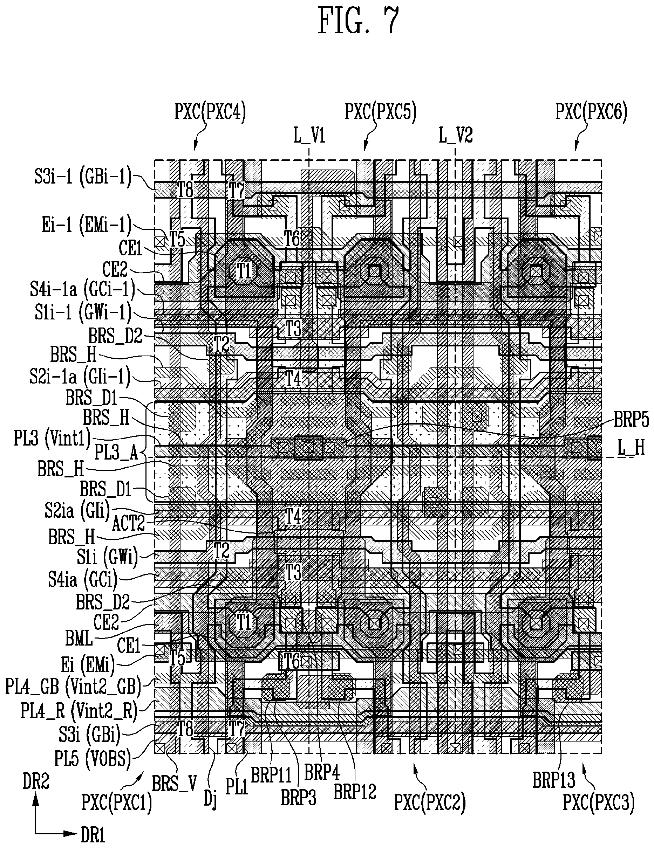

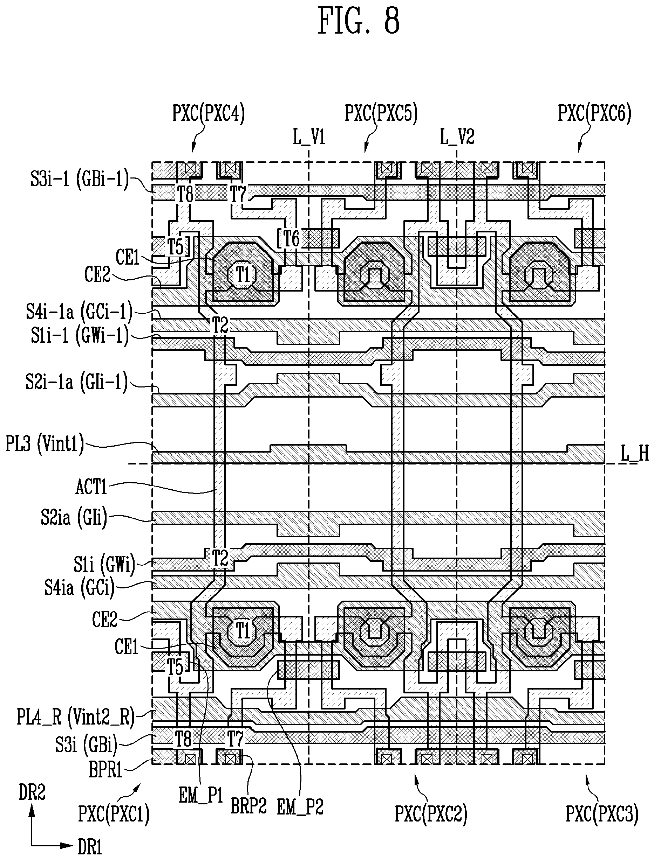

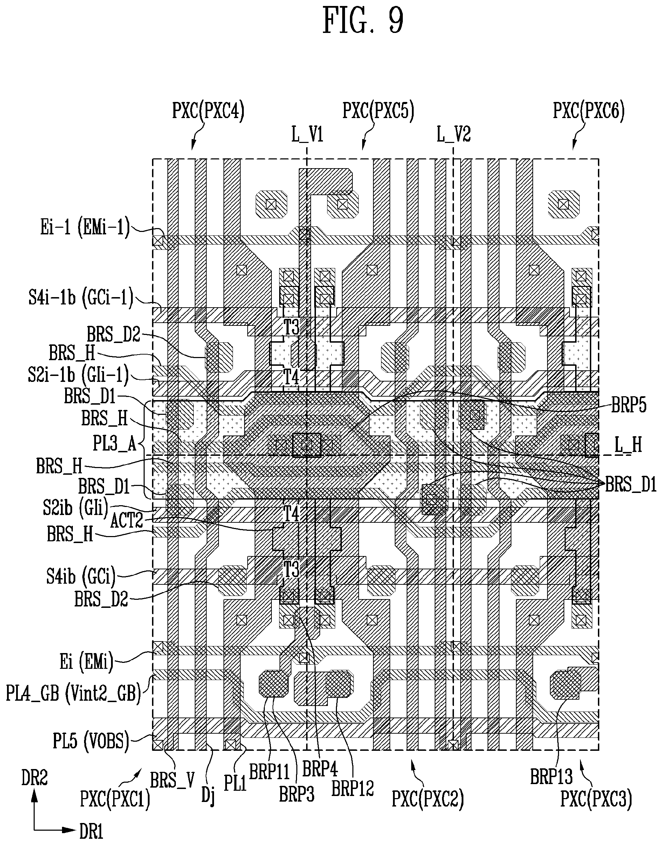

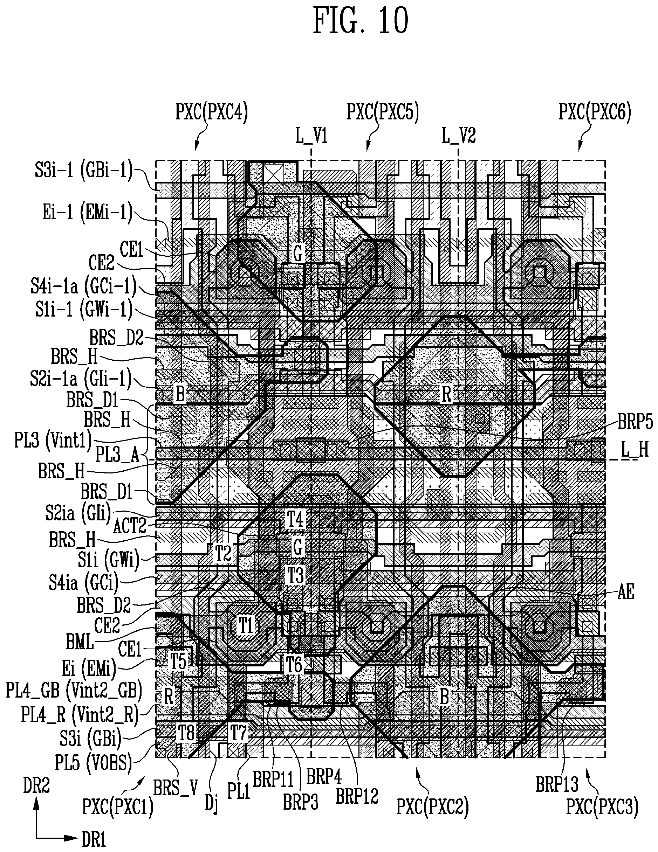

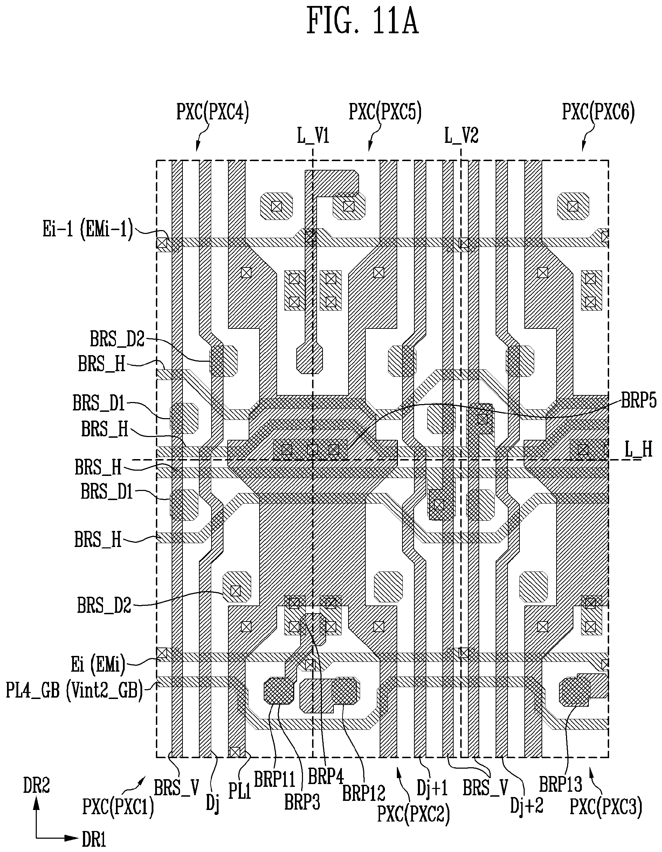

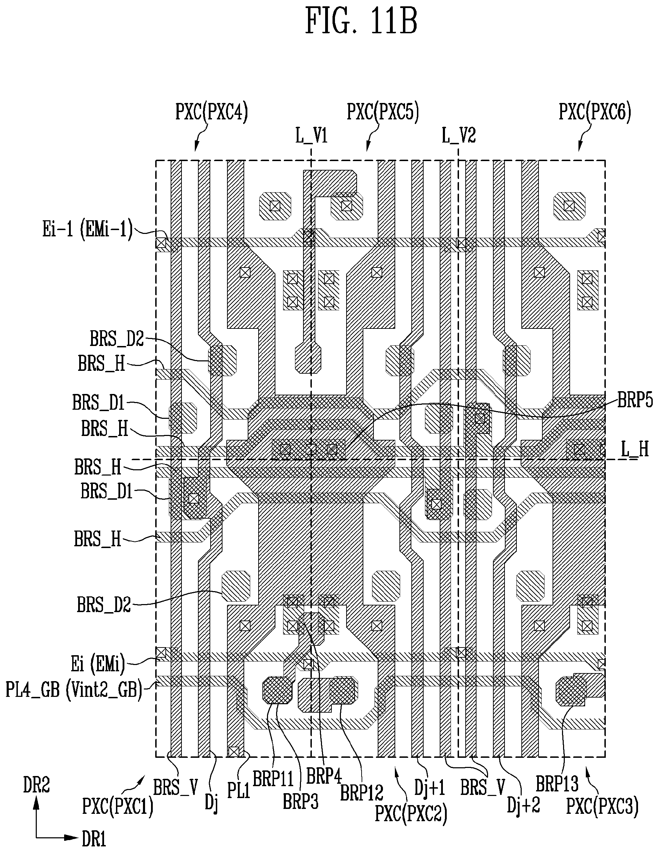

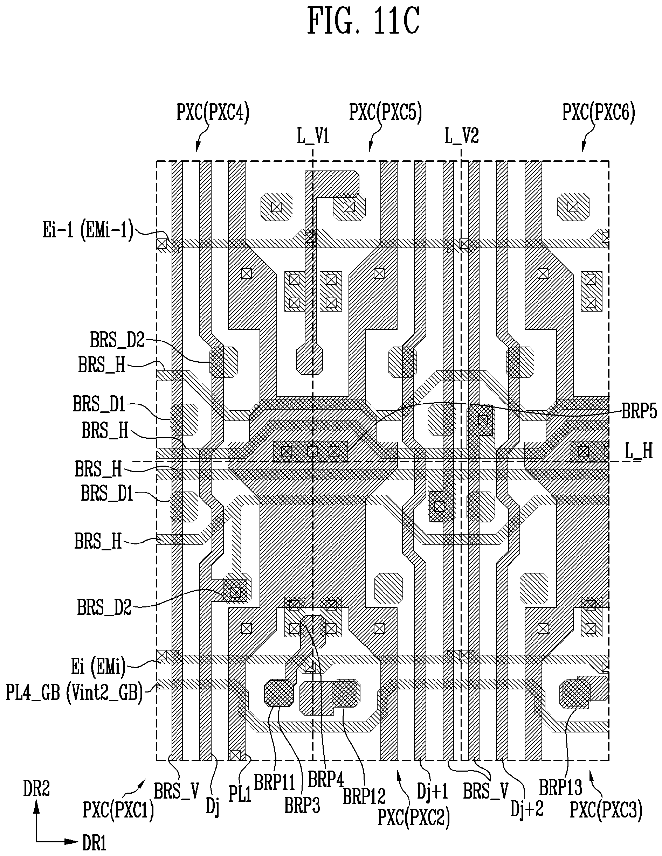

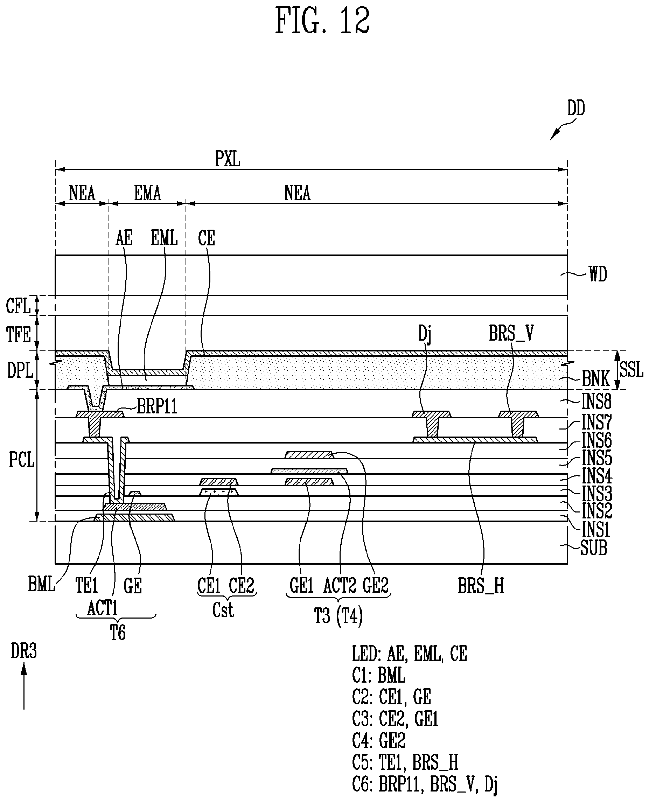

FIGS. 7, 8, 9, and 10 are plan views illustrating an embodiment of the display device of FIG. 5B. FIGS. 7, 8, 9, and 10 illustrate examples of a total of 6 pixel circuits disposed in two pixel rows. Based on FIG. 12, FIG. 7 illustrates the configuration of a pixel circuit layer PCL, FIG. 8 illustrates the configuration between a first insulating layer INS1 to a fourth insulating layer INS4, FIG. 9 illustrates the configuration between the fourth insulating layer INS4 to an eighth insulating layer INS8, and FIG. 10 additionally illustrates the configuration of a display element layer DPL compared to the configuration in FIG. 7. FIGS. 11A, 11B, and 11C are plan views illustrating an embodiment of the display device of FIG. 5B. FIGS. 11A, 11B, and 11C illustrate examples of the configuration between a sixth insulating layer INS6 to an eighth insulating layer INS8 of FIG. 12. FIG. 12 is a cross-sectional view illustrating an embodiment of the display device of FIG. 5B. FIG. 12 illustrates a cross-section of the third transistor T3 and the sixth transistor T6 among the first to eighth transistors T1, T2, T3, T4, T5, T6, T7, T8 of FIG. 3.

FIGS. 7 to 12 illustrate pixels simplified by representing each electrode as a single-film electrode and representing each insulating layer as a single-film insulating layer, but embodiments of the present disclosure are not limited thereto.

Referring to FIGS. 7 to 12, a first pixel circuit PXC1 may be a 44^{th} pixel circuit PXC44 of FIG. 5C, a second pixel circuit PXC2 may be a 45^{th} pixel circuit PXC45 of FIG. 5C, a third pixel circuit PXC3 may be a 46^{th} pixel circuit PXC46 of FIG. 5C, a fourth pixel circuit PXC4 may be a 34^{th} pixel circuit PXC34 of FIG. 5C, a fifth pixel circuit PXCS5 may be a 35^{th} pixel circuit PXC35 of FIG. 5C, and a sixth pixel circuit PXC6 may be a 36^{th} pixel circuit PXC36 of FIG. 5C. However, this is illustrative and embodiments of the present disclosure are not limited thereto.

The second pixel circuit PXC2 is left-right symmetrical to the first pixel circuit PXC1 based on a first vertical reference line L_V1, and the third pixel circuit PXC3 may be left-right symmetrical to the second pixel circuit PXC2 with respect to a second vertical reference line L_V2, or be substantially identical to the first pixel circuit PXC1. The fourth pixel circuit PXC4, fifth pixel circuit PXC5, and sixth pixel circuit PXC6 located in an (i-1)^{th} pixel row may be vertically symmetrical to the first pixel circuit PXC 1, second pixel circuit PXC2, and third pixel circuit PXC3 located in an i^{th} pixel row with respect to a horizontal reference line L_H. Therefore, pixel circuits PXC will be described based on the first pixel circuit PXC1, and a redundant description will be omitted.

Hereinafter, with reference to FIG. 12, components will be described in order of layers stacked on a substrate SUB.

A pixel circuit layer PCL may be disposed on the substrate SUB. The pixel circuit layer PCL may include first to eighth insulating layers INS1, INS2, INS3, INS4, INS5, INS6, INS7, INS8 stacked sequentially on the substrate SUB along a third direction DR3, and a first semiconductor pattern ACT1, a second semiconductor pattern ACT2, and first to sixth conductive layers C1, C2, C3, C4, C5, C6, which are individually disposed between two of the substrate SUB and the first to eighth insulating layers INS1, INS2, INS3, INS4, INS5, INS6, INS7, INS8.

The first conductive layer C1 may be disposed on the substrate SUB. The first conductive layer C1 may include a bottom electrode BML.

The bottom electrode BML may overlap the first transistor T1 (or first capacitor electrode CE1, second capacitor electrode CE2) in a plan view. The bottom electrode BML may shield the first transistor T1 (or first capacitor electrode CE1, second capacitor electrode CE2) at the bottom. A constant voltage may be applied to the bottom electrode BML. For example, although a first power voltage VDD may be applied to the bottom electrode BML, embodiments of the present disclosure are not limited thereto. The bottom electrode BML may extend along a first direction DR1 and a second direction DR2 based on the first transistor T1. The bottom electrode BML may have a mesh structure across a display area.

The first conductive layer C1 may include a conductive material. For example, the conductive material may include copper (Cu), molybdenum (Mo), tungsten (W), aluminum neodymium (AlNd), titanium (Ti), aluminum (Al), silver (Ag), and alloys thereof.

The first insulating layer INS1 (or buffer layer) may be provided on the substrate SUB to cover the bottom electrode BML. The first insulating layer INS1 may be an insulating film including an inorganic material. For example, the inorganic material may include at least one of the following metal oxides, such as silicon nitride (SiNₓ), silicon oxide (SiOₓ), silicon oxynitride (SiOₓN_{y}), and aluminum oxide (AlOₓ). The first insulating layer INS1 may be provided in the form of a single film, or may be provided in the form of a multi-film including at least two films. The first insulating layer INS1 may prevent the diffusion of impurities to a transistor.

The first semiconductor pattern ACT1 (or, first active pattern, first semiconductor layer) may be disposed on the first insulating layer INS1. The first semiconductor pattern ACT1 may be formed as a polysilicon semiconductor.

The first semiconductor pattern ACT1 that overlaps the first capacitor electrode CE1 may constitute a channel area of the first transistor T1. The first semiconductor pattern ACT1 may extend from both ends of the channel area of the first transistor T1 in the first direction DR1 or the opposite direction of the first direction DR1, and the first semiconductor pattern ACT1 that overlaps a first conductive pattern EM_P1 (and an i^{th} light emission control line Ei) may constitute a channel area of the fifth transistor T5, and the first semiconductor pattern ACT1 that overlap a second conductive pattern EM_P2 (and the i^{th} light emission control line Ei) may constitute a channel area of the sixth transistor T6.

The first semiconductor pattern ACT1 may further extend from the channel area of the sixth transistor T6 in the opposite direction of the second direction DR2, and the first semiconductor pattern ACT1 that overlaps a 3i^{th} scan line S3i may constitute a channel area of the seventh transistor T7. The first semiconductor pattern ACT1 may further extend from the channel area of the fifth transistor T5 in the opposite direction of the second direction DR2, and the first semiconductor pattern ACT1 that overlaps the 3i^{th} scan line S3i may constitute a channel area of the eighth transistor T8. The first semiconductor pattern ACT1 may extend from the left end of the channel area of the first transistor T1 in the second direction DR2, and the first semiconductor pattern ACT1 that overlaps an 1i^{th} scan line S1i may constitute a channel area of the second transistor T2.

A channel area, for example, may be a semiconductor pattern that is not doped with impurities, and may be an intrinsic semiconductor. The remaining area of the semiconductor panel (e.g., the remaining area of the first semiconductor pattern ACT1) excluding the channel area may be a semiconductor pattern doped with impurities.

The second insulating layer INS2 (or first gate insulating layer) may be disposed on the first semiconductor pattern ACT1. The second insulating layer INS2 may be an insulating layer including an inorganic material.

The second conductive layer C2 may be disposed on the second insulating layer INS2. The second conductive layer C2 may include the first capacitor electrode CE1, the first conductive pattern EM_P1, the second conductive pattern EM_P2, the 1i^{th} scan line S11, and the 3i^{th} scan line S3i. The second conductive layer C2 may include a conductive material.

The first capacitor electrode CE1 that overlaps the first semiconductor pattern ACT1 may constitute a gate electrode of the first transistor T1.

The first conductive pattern EM_P1 (or a first bridge pattern) that overlaps the first semiconductor pattern ACT1 may constitute a gate electrode of the fifth transistor T5, and the second conductive pattern EM_P2 (or a second bridge pattern) that overlaps the first semiconductor pattern ACT1 may constitute a gate electrode of the sixth transistor T6. The first conductive pattern EM_P1 and the second conductive pattern EM_P2 may be connected to the i^{th} light emission control line Ei.

In a plan view, the 1i^{th} scan line S11 and the 3i^{th} scan line S3i are spaced apart by including the first capacitor electrode CE1 therebetween, and the 1i^{th} scan line S1i and the 3i^{th} scan line S3i may each extend in the first direction DR1. The 1i^{th} scan line S1i of the i^{th} pixel row may be vertically symmetrical to an (1i-1)^{th} scan line S1i-1 of the (i-1)^{th} pixel row with respect to a third power line PL3. Similarly, the 3i^{th} scan line S3i of the i^{th} pixel row may be vertically symmetrical to an (3i-1)^{th} scan line S3i-1 of the (i-1)^{th} pixel row with respect to the third power line PL3.

The 1i^{th} scan line S1i that overlaps the first semiconductor pattern ACT1 may constitute the gate electrode of the second transistor T2. The 3i^{th} scan line S3i that overlaps the first semiconductor pattern ACT1 may constitute the gate electrode of the seventh transistor T7 and the gate electrode of the eighth transistor T8.

The third insulating layer INS3 (or a first interlayer insulating layer) may be disposed on the second conductive layer C2. The third insulating layer INS3 may be an insulating layer including an inorganic material.

The third conductive layer C3 may be disposed on the third insulating layer INS3. The third conductive layer C3 may include the third power line PL3, the second capacitor electrode CE2, a 2ia^{th} scan line S2ia (or a first sub-scan line), a 4ia^{th} scan line S4ia (or a second sub-scan line), and a (4-1)^{th} power line PL4_R. The third conductive layer C3 may include a conductive material. The 2ia^{th} scan line S2ia and a 2ib^{th} scan line (or a third sub-scan line) may constitute a 2i^{th} scan line S2i, and the 4ia^{th} scan line S4ia and the 4ib^{th} scan line S4ib (or a fourth sub-scan line) may constitute a 4i^{th} scan line S4i.

The third power line PL3 may be disposed between the first pixel circuit PXC1 and the fourth pixel circuit PXC4. The first pixel circuit PXC1 and the fourth pixel circuit PXC4 may share the third power line PL3. The third power line PL3 is not assigned to each of the first pixel circuit PXC1 and the fourth pixel circuit PXC4, but one third power line PL3 may be disposed for the first pixel circuit PXC1 and the fourth pixel circuit PXC4. Based on the third power line PL3, the first pixel circuit PXC1 and the fourth pixel circuit PXC4 may have a top-bottom symmetrical structure.

The second capacitor electrode CE2 may overlap the first capacitor electrode CE1, and may form the storage capacitor Cst. Most of the second capacitor electrode CE2 may overlap the first capacitor electrode CE1. The second capacitor electrode CE2 may include an opening that exposes the first capacitor electrode CE1.

The (4-1)^{th} power line PL4_R may be included in a fourth power line PL4 (see FIG. 3), and a (2-1)^{th} initialization power voltage Vint2_R may be provided for a first color pixel that emits light in a first color (e.g., red). The first color pixel has an operating point different from a second color pixel that emits light in a second color (e.g., green or blue), and in consideration of this, a second initialization power voltage Vint2 (e.g., the (2-1)^{th} initialization power voltage Vint2_R)) different from the second color pixel may be applied to the (4-1)^{th} power line PL4_R.

The (4-1)^{th} power line PL4_R may be disposed between the first pixel circuit PXC1 in the i^{th} pixel row and a pixel circuit in an (i+1)^{th} pixel row, and the first pixel circuit PXC1 in the i^{th} pixel row and the pixel circuit in the (i+1)^{th} pixel row may share the (4-1)^{th} power line PL4_R. The (4-1)^{th} power line PL4_R may not be disposed for each pixel circuit PXC, and a single (4-1)^{th} power line PL4_R may be disposed for the pixel circuits PXC in two pixel rows. The pixel circuit PXC in the i^{th} pixel row and the pixel circuit PXC in the (i+1)^{th} pixel row may have a top-bottom symmetrical structure with respect to the (4-1)^{th} power line PL4_R.

In a plan view, the third power line PL3, the 2ia^{th} scan line S2ia, the 4ia^{th} scan line S4ia, and the (4-1)^{th} power line PL4_R may be mutually spaced apart in the second direction DR2, and the 2ia^{th} scan line S2ia, the 4ia^{th} scan line S4ia, and the (4-1)^{th} power line PL4_R may each extend in the first direction DR1.

The fourth insulating layer INS4 may be disposed on the third conductive layer C3. The fourth insulating layer INS4 may be an insulating layer include an inorganic material.

The second semiconductor pattern ACT2 (or second active pattern, second semiconductor layer) may be disposed on the fourth insulating layer INS4. The second semiconductor pattern ACT2 may formed as an oxide semiconductor. The second semiconductor pattern ACT2 may extend in the second direction DR2.

The second semiconductor pattern ACT2 that overlaps the 4ib^{th} scan line S4ib (and the 4ia^{th} scan line S4ia) may constitute the channel area of the third transistor T3, and the second semiconductor pattern ACT2 that overlaps the 2ib^{th} scan line S2ib (and the 2ia^{th} scan line S2ia) may constitute the channel area of the fourth transistor T4.

In addition, from the end of the channel area of the fourth transistor T4, the second semiconductor pattern ACT2 may extend in the first direction DR1, and the second semiconductor pattern ACT2 doped with impurities may constitute a third auxiliary power line PL3_A. The third auxiliary power line PL3_A may be connected to the third power line PL3 via a contact hole. The third auxiliary power line PL3_A may reduce a resistance of the third power line PL3 and a voltage drop of the first initialization power voltage Vint1.

The fifth insulating layer INS5 (or second gate insulating layer) may be disposed on the second semiconductor pattern ACT2. The fifth insulating layer INS5 may be an insulating layer including an inorganic material.

The fourth conductive layer C4 may be disposed on the fifth insulating layer INS5. The fourth conductive layer C4 may include the 2ib^{th} scan line S2ib (or third sub-scan line), the 4ib^{th} scan line S4ib (or fourth sub-scan line), and a fifth power line PL5. The fourth conductive layer C4 may include a conductive material.

The 2ib^{th} scan line S2ib, 4ib^{th} scan line S4ib, and 5th power line PL5 are mutually spaced apart in the second direction DR2, and the 2ib^{th} scan line S2ib, 4ib^{th} scan line S4ib, and fifth power line PL5 may each extend in the first direction DR1.

The 2ib^{th} scan line S2ib may overlap the 2ia^{th} scan line S2ia. The 2ib^{th} scan line S2ib that overlaps the second semiconductor pattern ACT2 may constitute a gate electrode (or first gate electrode) of the fourth transistor T4. On the other hand, the 2ia^{th} scan line S2ia that overlaps the second semiconductor pattern ACT2 may constitute a bottom gate electrode (or second gate electrode) of the fourth transistor T4.

The 4ib^{th} scan line S4ib may overlap the 4ia^{th} scan line S4ia. The 4ib^{th} scan line S4ib that overlaps the second semiconductor pattern ACT2, may constitute a gate electrode (or first gate electrode) of the third transistor T3. On the other hand, the 4ia^{th} scan line S4ia that overlaps the second semiconductor pattern ACT2 may constitute a bottom gate electrode (or second gate electrode) of the third transistor T3.

The fifth power line PL5 may be connected to the first bridge pattern BRP1, and, through the first bridge pattern BRP1, may be connected to the first semiconductor pattern ACT1 that constitutes the eighth transistor T8.

The fifth power line PL5 is disposed between the first pixel circuit PXC1 in the i^{th} pixel row and the pixel circuit in the (i+1)^{th} pixel row, and the first pixel circuit PXC1 in the i^{th} pixel row and the pixel circuit in the (i+1)^{th} pixel row may share the fifth power line PL5. The fifth power line PL5 may not be disposed for each pixel circuit PXC, but may be disposed for pixel circuits PXC in two pixel rows. The pixel circuit PXC in the i^{th} pixel row and the pixel circuit PXC in the (i+1)^{th} pixel row may have a top-bottom symmetrical structure with respect to the fifth power line PL5.

The sixth insulating layer INS6 (or a second interlayer insulating layer) may be disposed on the fourth conductive layer C4. The sixth insulating layer INS6 may be an insulating layer including an inorganic material.

The fifth conductive layer C5 may be disposed on the sixth insulating layer INS6. The fifth conductive layer C5 may include the i^{th} light emission control line Ei, a (4-2)^{th} power line PL4_GB, a connection line BRS_H, a first dummy pattern BRS_D1, a second dummy pattern BRS_D2, a third bridge pattern BRP3, a fourth bridge pattern BRP4, and a fifth bridge pattern BRP5. The fifth conductive layer C5 may include a conductive material.

The i^{th} light emission control line Ei may extend in the first direction DR1 and may be connected to the first conductive pattern EM_P1 and the second conductive pattern EM_P2 via a contact hole.

The (4-2)^{th} power line PL4_ GB may extend in the first direction DR1, generally. A (2-2)^{th} initialization power voltage Vint2_GB for the second color pixel that emits light in the second color (e.g., green or blue) may be applied to the (4-2)^{th} power line PL4_GB included in the fourth power line PL4 (see Fig. 3). The (4-2)^{th} power line PL4_GB may be disposed between the first pixel circuit PXC1 in the i^{th} pixel row and the pixel circuit in the (i+1)^{th} pixel row, and the first pixel circuit PXC1 in the i^{th} pixel row and the pixel circuit in the (i+1)^{th} pixel row may share the (4-2)^{th} power line PL4_GB. The (4-2)^{th} power line PL4_GB may not be disposed for each pixel circuit PXC, but may be disposed for the pixel circuits PXC within the two pixel rows.

The connection line BRS_H and the third power line PL3 may be disposed between the first pixel circuit PXC1 of the i^{th} pixel row and the fourth pixel circuit PXC4 of the (i-1)^{th} pixel row. Four connection lines BRS_H may be disposed between the first pixel circuit PXC1 and the fourth pixel circuit PXC4. For example, four connection lines BRS_H may be disposed between the 2ib^{th} scan line S2ib of the i^{th} pixel row and the (2i-1b)^{th} scan line S2i-1b of the (i-1)^{th} pixel row, or between the 1i^{th} scan line S1i of the i^{th} pixel row and the (1i-1)^{th} scan line S1i-1 of the (i-1)^{th} pixel row. However, embodiments of the present disclosure are not limited thereto. For example, in two pixel rows and between two corresponding scan lines (or gate lines), three connection lines BRS_H may be disposed as described in reference to FIG. 5A, or two connection lines BRS_H may be may be disposed as described in reference to FIG. 5C. Based on at least one connection line BRS_H, the first pixel circuit PXC1 and the fourth pixel circuit PXC4 may have a top-bottom symmetrical structure.

The connection line BRS_H usually extends in the first direction DR1, but at least one connection line BRS_H may have a curved part that bypasses the first dummy pattern BRS_D1 (and contact hole). For example, the connection line BRS_H located at the first and fourth positions in the second direction DR2 may have a curved shape so as to be spaced a predetermined distance apart from the first dummy pattern BRS_D1.

In an embodiment, a connection line BRS_H that is not used to connect a data line and a bridge line BRS_V may be disconnected (open) along the first direction DR1. For example, the connection line BRS_H may include a plurality of patterns spaced apart from each other along the first direction DR1.

The first dummy pattern BRS_D1 may be disposed between the connection line BRS_H in the i^{th} row and the connection line BRS_H in the (i-1)^{th} row. In addition, the first dummy pattern BRS_D1 may be disposed between two data lines Dj+1, Dj+2. As illustrated in FIG. 9, four first dummy patterns BRS_D1 may be disposed in an area where the horizontal reference line L_H and the second vertical reference line L_V2 intersect. The first dummy pattern BRS_D1 may overlap the bridge lines BRS _V, but embodiments of the present disclosure are not limited thereto.

**In** an embodiment, the first dummy pattern BRS_D1 may be utilized to connect a connection line BRS_H and a bridge line BRS_V.

Referring to FIG. 11A, for example, a connection line BRS_H that passes through the i^{th} pixel row and is adjacent to the horizontal reference line L_H may be formed integrally with the first dummy pattern BRS_D1 located in the second pixel circuit PXC2, and a bridge line BRS_V that overlaps the first dummy pattern BRS_D1 (i.e., a bridge line BRS_V passing through the second pixel circuit PXC2) may be connected to the first dummy pattern BRS_D1 (and connection line BRS_H) through a contact hole (i.e., a contact hole penetrating the seventh insulating layer INS7). Similarly, a connection line BRS_H that passes through the (i-1)^{th} pixel row and is adjacent to the horizontal reference line L_H may be formed integrally with the first dummy pattern BRS_D1 located in the sixth pixel circuit PXC6, and a bridge line BRS_V that overlaps the first dummy pattern BRS_D1 (i.e., a bridge line BRS_V passing through the third pixel circuit PXC3) may be connected to the first dummy pattern BRS_D1 (and connection line BRS_H) via a contact hole. For example, the first dummy pattern BRS_D1 may be used for the connection between the first connection line BRS_H1 and the third bridge line BRS_V3, and for the connection between the second connection line BRS_H2 and the fourth bridge line BRS_V4 shown in FIG. 4.

The first dummy pattern BRS_D1 that is not connected to the connection line BRS_H may be in a floating state, but embodiments of the present disclosure are not limited thereto. For example, a bridge line BRS_V may be connected to the first dummy pattern BRS_D1 (i.e., the first dummy pattern BRS_D1 that is not connected to the connection line BRS_H) via a contact hole. As a contact hole for the connection between a bridge line BRS_V and the first dummy pattern BRS_D1 is uniformly disposed across the display device DD, the effect of the contact hole on a pixel circuit PXC is uniform, and the pixel circuit PXC may have uniform characteristics, generally.

In an embodiment, the first dummy pattern BRS_D1 may be used to connect a connection line BRS_H and a data line. Referring to FIG. 11B, for example, a connection line BRS_H that passes through the i^{th} pixel row and is adjacent to a horizontal reference line L_H may be formed integrally with the first dummy pattern BRS_D1 located in the first pixel circuit PXC1, and a j^{th} data line Dj that overlaps the first dummy pattern BRS_D1 may be connected to the first dummy pattern BRS_D1 (and connection line BRS_H) via a contact hole (i.e., a contact hole penetrating the seventh insulating layer INS7). For example, the first dummy pattern BRS_D1 may be used for the connection between the first connection line BRS_H1 and the third data line D3, as shown in FIG. 4.

The second dummy pattern BRS_D2 may be disposed between a connection line BRS_H and the i^{th} light emission control line Ei. The second dummy pattern BRS_D2 may be disposed for pixel circuit PXC, but embodiments of the present disclosure are not limited thereto.

**In** an embodiment, the second dummy pattern BRS_D2 may be used to connect a connection line BRS_H and a data line.

Referring to FIG. 11C, for example, a connection line BRS_H passing through the i^{th} pixel row may be formed integrally with the second dummy pattern BRS_D2 located in the first pixel circuit PXC1, and the j^{th} data line Dj that overlaps the second dummy pattern BRS_D2 may be connected to the second dummy pattern BRS_D2 (and connection line BRS_H) via a contact hole.

The third bridge pattern BRP3 may overlap the first semiconductor pattern ACT1 that constitutes the sixth transistor T6 and may be connected to the first semiconductor pattern ACT1 through a contact hole. The third bridge pattern BRP3 may constitute a first electrode TE1 (see FIG. 12) of the sixth transistor T6. The third bridge pattern BRP3 may be connected to an 11^{th} bridge pattern BRP11, and may be connected to an anode electrode AE via the 11^{th} bridge pattern BRP11. In other words, the third bridge pattern BRP3 may form the fourth node N4 of FIG. 3.

The fourth bridge pattern BRP4 may overlap the first semiconductor pattern ACT1 that constitutes the first transistor T1 and may be connected to the first semiconductor pattern ACT1 through a contact hole. In addition, the fourth bridge pattern BRP4 may overlap the second semiconductor pattern ACT2 that constitutes the third transistor T3 and may be connected to the second semiconductor pattern ACT2 through a contact hole. In other words, the fourth bridge pattern BRP4 may form the third node N3 of FIG. 3.

The fifth bridge pattern BRP5 may overlap the third power line PL3 and the third auxiliary power line PL3_A, and may be connected to the third power line PL3 and the third auxiliary power line PL3_A via a contact hole.

The seventh insulating layer INS7 may be disposed on the fifth conductive layer C5. The seventh insulating layer INS7 may be an insulating layer including an inorganic or organic material. For example, the organic material may include acrylic resin, epoxy resin, phenolic resin, polyamide resin, polyimide resin, and the like.

In an embodiment, a contact hole corresponding to each first dummy pattern BRS_D1 may be formed in the seventh insulating layer INS7. For example, between two connection lines BRS_H adjacent to each other, contact holes may be formed to correspond to the first dummy pattern BRS_D1. Through the contact holes, a bridge line BRS_V may be connected to the first dummy pattern BRS_D1 (and connection line BRS_H). In accordance with the embodiment, the data line may be connected to the first dummy pattern BRS_D1 (and connecting line BRS_H) through the contact holes.

The sixth conductive layer C6 may be disposed on the seventh insulating layer INS7. The sixth conductive layer C6 may be arranged with the first power line PL1, the data line Dj, Dj+1, Dj+2, the bridge line BRS_V, the 11^{th} bridge pattern BRP11, a 12^{th} bridge pattern BRP12, and a 13^{th} bridge pattern BRP13. The sixth conductive layer C6 may include a conductive material.

The first power line PL1, the data line Dj, Dj+1, Dj+2, and the bridge line BRS_V are spaced apart from each other along the first direction DR1, and the first power line PL1, the data line Dj, Dj+1, Dj+2, and the bridge line BRS_V may each extend along the second direction DR2.

The first power line PL1 may be connected to the second capacitor electrode CE2 via a contact hole.

The data line Dj, Dj+1, Dj+2 may be connected to the first semiconductor pattern ACT1 that constitutes the second transistor T2 (e.g., a portion where the first semiconductor pattern ACT1 protrudes in the first direction DR1 between the (1i-1a)^{th} scan line S1i-1a and the (2i-1a)^{th} scan line S2i-1a.

The bridge line BRS_V may overlap the first dummy pattern BRS_D1, and may be connected to the first dummy pattern BRS_D1 through a contact hole.

The 11^{th} bridge pattern BRP11 may overlap the third bridge pattern BRP3, and may be connected to the third bridge pattern BRP3. The 12^{th} bridge pattern BRP12 and the 13^{th} bridge pattern BRP13 are different in shape from the 11^{th} bridge pattern BRP11, but they serve the same purpose as the 11^{th} bridge pattern BRP11.

An eighth insulating layer INS8 may be disposed on the sixth conductive layer C6. The eighth insulating layer INS8 may be an insulating layer including an organic or inorganic material. In an embodiment, the eighth insulating layer INS8 may serve as a planarization layer.

A display element layer DPL may be disposed on the eighth insulating layer INS8. The display element layer DPL may include an anode electrode AE, a bank layer BNK, a light-emitting layer EML, and a cathode electrode CE. The anode electrode AE, the light-emitting layer EML, and the cathode electrode CE constitute the light-emitting element LED.

In an embodiment, the anode electrode AE may include a metal layer such as silver (Ag), magnesium (Mg), aluminum (Al), platinum (Pt), palladium (Pd), gold (Au), nickel (Ni), neodymium (Nd), iridium (Ir), chromium (Cr), or alloys thereof, or a transparent conductive layer such as indium tin oxide (ITO), indium zinc oxide (IZO), zinc oxide (ZnO), indium tin zinc oxide (ITZO), or the like. The anode electrode AE may be connected to the 11^{th} bridge pattern BRP11 via a contact hole.

A bank layer BNK (or pixel definition film) that comparts or defines a light emission area EMA and a non-light emitting area NEA may be provided on the anode electrode AE. The bank layer BNK may be an insulating layer including an organic material.

Depending on the embodiment, the bank layer BNK may include a light-absorbing material, or a light-absorbing agent may be applied thereto to enable absorption of light from the outside. For example, the bank layer BNK may include a carbon-based black pigment. However, embodiments of the present disclosure are not limited thereto, and the bank layer BNK may also include an opaque metallic material such as chromium (Cr), molybdenum (Mo), alloys of molybdenum and titanium (MoTi), tungsten (W), vanadium (V), niobium (Nb), tantalum (Ta), manganese (Mn), cobalt (Co), or nickel (Ni) with a high light absorption rate.

The light-emitting layer EML may be provided in the top surface of the anode electrode AE exposed by the bank layer BNK. In an embodiment, the light-emitting layer EML may include an organic light-emitting layer. Depending on the organic material included in the light-emitting layer EML, the light-emitting layer EML may emit light such as red light, green light, blue light, or the like.

The cathode electrode CE may be provided on the light-emitting layer EML. The cathode electrode CE may be a common electrode that is integrally formed on a display area DA. The cathode electrode CE may be connected to the second power line (see PL2, FIG. 3), and a second power voltage VSS may be supplied to the cathode electrode CE.

The cathode electrode CE may include a metal layer such as silver (Ag), magnesium (Mg), aluminum (Al), platinum (Pt), palladium (Pd), gold (Au), nickel (Ni), neodymium (Nd), iridium (Ir), chromium (Cr) or a transparent conductive layer such as ITO, IZO, ZnO, ITZO, or the like. In an embodiment, the cathode electrode CE may be provided in the form of a multi-layer including two or more layers including a metal thin layer, for example, a triple layer of ITO/Ag/ITO.

An encapsulation layer TFE may be provided on the cathode electrode CE. The encapsulation layer TFE may include a single layer, or may include multiple layers. In an embodiment, the encapsulation layer TFE may have a structure in which layers are deposited in the order of an inorganic material, an organic material, and an inorganic material. The top layer of the encapsulation layer TFE may include an inorganic material.

As described above, pixel circuits (or pixels) of two pixel rows adjacent to each other may have a top-bottom symmetrical structure, the two pixel rows may share at least one power line (e.g., the third power line PL3), and at least two connection lines BRS_H may be disposed for each pixel row. In other words, multiple connection lines BRS_H may be disposed for each pixel row without increasing the area of a pixel circuit PXC.

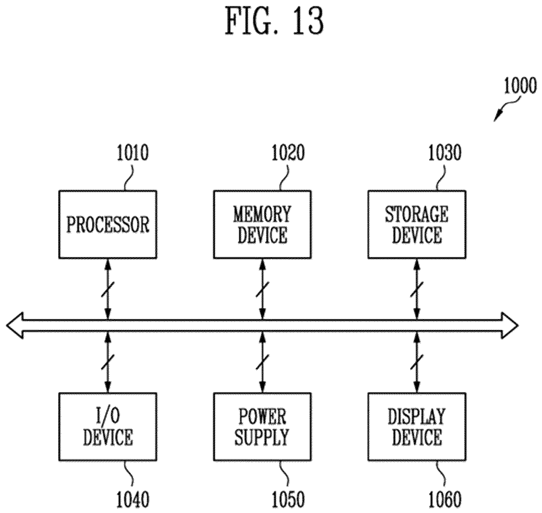

FIG. 13 is a block diagram schematically illustrating an electronic device according to embodiments.

Referring to FIG. 13, the electronic device 1000 may include a processor 1010, a memory device 1020, a storage device 1030, an input/output (I/O) device 1040, a power supply 1050, and a display device 1060. The display device 1060 may be the display device DD of FIG. 1. The electronic device 1000 may further include various ports for communication with a video card, a sound card, a memory card, a USB device, or other systems. In an embodiment, the electronic device 1000 may be a smartphone. In an embodiment, the electronic device 1000 may be a tablet computer. However, the aforementioned examples are illustrative, and the electronic device 1000 is not necessarily limited to the aforementioned examples. For example, the electronic device 1000 may be a cellular phone, a video phone, a smart pad, a smartwatch, a navigation device for vehicles, a computer monitor, a laptop computer, a head-mounted display device, or the like.

The processor 1010 may perform specific calculations or tasks. In an embodiment, the processor 1010 may include at least one of a central processing unit, an application processor, a graphic processing unit, a communication processor, an image signal processor, a controller, or the like. The processor 1010 may be connected to other components through an address bus, a control bus, a data bus, and the like. In an embodiment, the processor 1010 may be connected to an expansion bus such as a peripheral component interconnect (PCI) bus. In an embodiment, the processor 1010 may provide input image data to the display device 1060. Hence, the display device 1060 may display an image based on the input image data provided from the processor 1010.

The memory device 1020 may store data needed to perform the operation of the electronic device 1000. The memory device 1020 may function as a working memory or a buffer memory for the processor 1010. For example, the memory device 1020 may include one or more volatile memory devices such as a dynamic random access memory (DRAM) device, a static random access memory (SRAM) device, and a mobile DRAM device.

The storage device 1030 may store data in response to control signals or data from the processor 1010. The storage device 1030 may include one or more non-volatile storages to retain the data even when the electronic device 1000 is powered off. In some embodiments, the storage device 1030 may include a solid state drive (SSD), a hard disk drive (HDD), a CD-ROM, or the like.

The I/O device 1040 may include input devices such as a keyboard, a keypad, a touchpad, a touch screen, and a mouse, and output devices such as a speaker and a printer. In an embodiment, the display device 1060 may be integrated with the I/O device 1040.

The power supply 1050 may supply power needed to perform the operation of the electronic device 1000. For example, the power supply 1050 may include a power management integrated circuit (PMIC). In an embodiment, the power supply 1050 may supply power to the display device 1060.

The display device 1060 may display images in response to image data signals or control signals from the processor 1010. The display device 1060 may be connected to other components through the buses or other communication links.

Embodiments can provide a display device comprising: a first gate line and a second gate line extending in a first direction and arranged along a second direction that intersects the first direction; data lines extending in the second direction and arranged along the first direction; first pixels connected to the first gate line in common, and connected to the data lines respectively; second pixels connected to the second gate line in common, and connected to the data lines respectively; and connection lines disposed between the first gate line and the second gate line, at least one of the connection lines being connected to a corresponding data line among the data lines, wherein each of the first and second pixels comprises a light emitting element and a pixel circuit, and the pixel circuit comprises transistors, and wherein the pixel circuit of a first pixel of the first pixels and the pixel circuit of a second pixel of the second pixels are mutually symmetrical with respect to a connection line of the connection lines in a plan view.

The pixel circuit of the first pixel of the first pixels and the pixel circuit of a second pixel of the second pixels may be mutually symmetrical with respect to their transistor arrangements.

The pixel circuits may be arranged in rows and columns.

Each of the pixel rows may extend in a first direction and may be aligned along a second direction. Each of the pixel columns may extend in the second direction and may be aligned along the first direction.

**In** some embodiments, the pixel circuits included in two adjacent pixel columns may be left-right symmetrical. For example, a pixel in one column may have a certain arrangement of transistors and another pixel in an adjacent column may have an arrangement of transistors that is respectively symmetrical.

**In** some embodiments, the pixel circuits included in two adjacent pixel rows may be vertically symmetrical or flipped. For example, the transistors of a pixel circuit may be disposed to be respectively symmetrical to the transistors of a pixel circuit adjacent in the second direction.

In some embodiments, sub-pixels of even/odd rows are flipped. That is, the sub-pixels in two adjacent rows have structures that are vertically symmetrical to each other. Power lines (e.g., VINT) are shared by the sub-pixels of two rows. In this case, the number of power lines can be reduced.

Embodiments can provide a display device comprising: gate lines extending in a first direction and arranged along a second direction that intersects the first direction; data lines extending in the second direction and arranged along the first direction; pixels connected to the gate lines and the data lines, the pixels arranged in pixel rows and pixel columns; and connection lines extending in the first direction and disposed between the gate lines, at least one of the connection lines being connected to a corresponding data line among the data lines, wherein at least two connection lines are disposed for each pixel row, and the pixel row corresponds to each of the gate lines.

Embodiments can provide an electronic device, comprising: a processor arranged to provide input image data; and a display device arranged to display an image based on the input image data, wherein the display device is according to any of the above mentioned embodiments.

While the present disclosure has been described with reference to embodiments thereof, it will be apparent to those of ordinary skill in the art that various changes and modifications may be made thereto without departing from the scope of the present disclosure as set forth in the following claims.

## Claims

1. A display device comprising:
a first gate line and a second gate line extending in a first direction and arranged along a second direction that intersects the first direction;
data lines extending in the second direction and arranged along the first direction;
first pixels connected to the first gate line in common, and connected to the data lines respectively;
second pixels connected to the second gate line in common, and connected to the data lines respectively; and
connection lines disposed between the first gate line and the second gate line, at least one of the connection lines being connected to a corresponding data line among the data lines,
wherein each of the first and second pixels comprises a light emitting element and a pixel circuit, and the pixel circuit comprises transistors, and
wherein the pixel circuit of a first pixel of the first pixels and the pixel circuit of a second pixel of the second pixels are mutually symmetrical with respect to a connection line of the connection lines in a plan view.

2. The display device according to claim 1, wherein the first pixels are disposed in a first row, and the second pixels are disposed in a second row adjacent to the first row.

3. The display device according to claim 1 or 2, wherein the transistors of the second pixels are disposed to be symmetrical to the transistors of the first pixels with respect to one of the connection lines in a plan view.

4. The display device according to claim 3, wherein the first gate line and the second gate line have shapes that are symmetrical with respect to one of the connection lines in a plan view.

5. The display device according to any one of claims 1 to 4, wherein the connection lines extend in the first direction, are arranged along the second direction between the first gate line and the second gate line, and are connected to different data lines from each other among the data lines.

6. The display device according to any one of claims 1 to 5, wherein each of the first pixels and the second pixels comprises a first switching transistor which is connected to a corresponding data line among the data lines and of which a gate electrode is electrically connected to one of the first and second gate lines.

7. The display device according to any one of claims 1 to 8, further comprising:
a power line that extends in the first direction between the first gate line and the second gate line,
wherein the first pixels and the second pixels are connected to the power line in common, and
wherein each of the first pixels and the second pixels comprises a second switching transistor which is connected to the power line and of which a gate electrode is electrically connected to one of the first and second gate lines.

8. The display device according to any one of claims 1 to 8, wherein at least two connection lines are disposed between the first gate line and the second gate line;
optionally wherein four connection lines are disposed between the first gate line and the second gate line or wherein three connection lines are disposed between the first gate line and the second gate line.

9. The display device according to any one of claims 1 to 8, wherein two pixels adjacent to each other among the first pixels are symmetrical with respect to one of the data lines.

10. The display device according to any one of claims 1 to 9, further comprising:
bridge lines disposed between two data lines adjacent to each other among the data lines, extending in the second direction, and connected to a corresponding connection line among the connection lines,
wherein the first pixel receives a data signal sequentially passing through a bridge line of the bridge lines, a connection line of the connection lines, and a data line of the data lines.

11. The display device according to claim 10, wherein an insulating layer is disposed between the bridge lines and the connection lines in a cross-sectional view, and contact holes that penetrate the insulating layer are formed between two connection lines adjacent to each other among the connection lines in a plan view, and
wherein the bridge line is connected to the connection line via a first contact hole;
optionally wherein the data line is connected to the connection line via a second contact hole;
optionally wherein one of the connection lines has a curved part that extends by bypassing the contact holes in a plan view.

12. The display device according to any one of claims 1 to 11, wherein the pixel circuit comprises:
a first transistor configured to control a current flowing through the light emitting element;
a fifth transistor connected between a first power line and the first transistor;
a sixth transistor connected between the first transistor and an anode electrode of the light emitting element; and
a seventh transistor connected between the anode electrode of the light emitting element and a fourth power line, and
wherein a first pixel row includes the first pixels and a second pixel row includes the second pixels;
wherein the first pixel row is adjacent to the second pixel row;
wherein the first pixel row and the second pixel row share the fourth power line;
wherein the pixel circuit further comprises an eighth transistor connected between a fifth power line and the first transistor and including a gate electrode connected to a gate electrode of the seventh transistor; and
wherein the first pixel row and the second pixel row share the fifth power line.

13. A display device comprising:
gate lines extending in a first direction and arranged along a second direction that intersects the first direction;
data lines extending in the second direction and arranged along the first direction;
pixels connected to the gate lines and the data lines, the pixels arranged in pixel rows and pixel columns; and
connection lines extending in the first direction and disposed between the gate lines, at least one of the connection lines being connected to a corresponding data line among the data lines,
wherein at least two connection lines are disposed for each pixel row, and the pixel row corresponds to each of the gate lines.

14. The display device according to claim 13, further comprising:
bridge lines extending in the second direction and disposed between the data lines, at least one of the bridge lines being connected to a corresponding connection line among the connection lines, wherein the bridge lines are disposed, one for each of the pixel columns, and the pixel columns correspond to the data lines; and/or
further comprising: power lines extending in the first direction and arranged along the second direction at intervals of pairs of adj acent pixel rows of the pixel rows, wherein the pixels included in each pair of the pairs of adj acent pixel rows share a power line of the power lines.

15. An electronic device, comprising:
a processor arranged to provide input image data; and
a display device arranged to display an image based on the input image data,
wherein the display device is according to any one of claims 1 to 14.
